(19) Europäisches Patentamt
European Patent Office
Office européen des brevets

(11) **EP 2 395 564 A1**

(12) **EUROPEAN PATENT APPLICATION**
published in accordance with Art. 153(4) EPC

(43) Date of publication:
**14.12.2011 Bulletin 2011/50**

(51) Int Cl.:
**H01L 31/068** (2006.01)

(21) Application number: **10738502.3**

(22) Date of filing: **02.02.2010**

(86) International application number:
**PCT/JP2010/051389**

(87) International publication number:
**WO 2010/090170 (12.08.2010 Gazette 2010/32)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **06.02.2009 JP 2009026416**

(71) Applicant: **Sharp Kabushiki Kaisha**
**Osaka-shi, Osaka 545-8522 (JP)**

(72) Inventors:
• **Agui, Takaaki**
**Oaka-shi,**
**Osaka 545-8522 (JP)**
• **TAKAMOTO, Tatsuya**
**Oaka-shi,**
**Osaka 545-8522 (JP)**

(74) Representative: **Müller - Hoffmann & Partner**
**Patentanwälte**
**Innere Wiener Strasse 17**
**81667 München (DE)**

(54) **COMPOUND SEMICONDUCTOR SOLAR CELL AND COMPOUND SEMICONDUCTOR SOLAR CELL MANUFACTURING METHOD**

(57) A compound semiconductor solar battery including a first compound semiconductor photoelectric conversion cell (40a), a second compound semiconductor photoelectric conversion cell (40b) provided on the first compound semiconductor photoelectric conversion cell (40a), and a compound semiconductor buffer layer (41) provided between the first compound semiconductor photoelectric conversion cell (40a) and the second compound semiconductor photoelectric conversion cell (40b), the first compound semiconductor photoelectric conversion cell (40a) and the compound semiconductor buffer layer (41) being provided adjacent to each other, and a ratio of a difference in lattice constant between the first compound semiconductor photoelectric conversion cell (40a) and a compound semiconductor layer (30) provided in a position closest to the first compound semiconductor photoelectric conversion cell (40a) among compound semiconductor layers constituting the compound semiconductor buffer layer (41) being not less than 0.15% and not more than 0.74%, and a method for manufacturing the same are provided.

FIG.1

| n | GaAs | 127 | |
| n | AlInP | 125 | |
| n | $In_xGa_{1-x}P$:x=0.48 | 124 | 40c |
| p | $In_xGa_{1-x}P$:x=0.48 | 123 | |
| p | AlInP | 122 | |
| p+ | AlInP | 121 | |
| p++ | AlGaAs | 120 | 50b |
| n++ | $In_xGa_{1-x}P$:x=0.48 | 119 | |
| n+ | AlInP | 118 | |
| n | $In_xGa_{1-x}P$:x=0.48 | 117 | |
| n | GaAs | 116 | 40b |
| p | GaAs | 115 | |
| p | $In_xGa_{1-x}P$:x=0.48 | 114 | |
| p+ | AlInP | 113 | |
| p++ | AlGaAs | 112 | 50a |
| n++ | $In_xGa_{1-x}P$:x=0.48 | 111 | |
| n+ | AlInP | 110 | |
| n+ | $In_xGa_{1-x}P$:x=0.48 | 21 | |
| n | $In_xGa_{1-x}P$:x=0.51 | 22 | |
| n | $In_xGa_{1-x}P$:x=0.55 | 23 | |
| n | $In_xGa_{1-x}P$:x=0.59 | 24 | |
| n | $In_xGa_{1-x}P$:x=0.63 | 25 | |
| n | $In_xGa_{1-x}P$:x=0.67 | 26 | 41 |
| n | $In_xGa_{1-x}P$:x=0.71 | 27 | |
| n | $In_xGa_{1-x}P$:x=0.75 | 28 | |
| n | $In_xGa_{1-x}P$:x=0.79 | 29 | |
| n | $In_xGa_{1-x}P$:x=0.82 | 30 | |
| n | InGaP | 31 | |
| n | InGaAs | 32 | 40a |
| p | InGaAs | 33 | |
| p | InGaP | 34 | |
| p | InGaAs | 35 | |
| | | 102 | |
| | | 101 | |

**Description**

TECHNICAL FIELD

The present invention relates to a compound semiconductor solar battery and a method for manufacturing the compound semiconductor solar battery.

BACKGROUND ART

A conventional method for increasing efficiency of a compound semiconductor solar battery (increasing photoelectric conversion efficiency) is to grow compound semiconductor layers having a lattice constant similar to that of a semiconductor substrate on the semiconductor substrate to form a plurality of compound semiconductor photoelectric conversion cells, thus obtaining a compound semiconductor solar battery having good crystallinity.

However, compound semiconductor solar batteries including compound semiconductor photoelectric conversion cells having a lattice constant similar to that of Si, Ge, GaAs, InP or the like which forms a main semiconductor substrate for growing compound semiconductor layers and further having a suitable forbidden band width have been limited to an InGaP/GaAs compound semiconductor solar battery including a GaAs substrate, an InGaP/InGaAs/Ge compound semiconductor solar battery including a Ge substrate, and so on.

One method for achieving higher efficiency than that of these compound semiconductor solar batteries is to dispose a compound semiconductor photoelectric conversion cell having a forbidden band width of 1 eV as a third compound semiconductor photoelectric conversion cell in an InGaP/GaAs solar battery.

Unfortunately, there are no appropriate compound semiconductors having a lattice constant similar to that of GaAs and a forbidden band width of approximately 1 eV. Although InGaAs having a lattice constant mismatched from that of GaAs by approximately 2.3% has a forbidden band width of approximately 1 eV, if InGaAs is used as a third compound semiconductor photoelectric conversion cell in an InGaP/GaAs compound semiconductor solar battery, a lattice-matched semiconductor is grown after a lattice-mismatched semiconductor is grown on a GaAs substrate, which may cause deterioration of crystallinity of the lattice-matched semiconductor, resulting in performance degradation of the entire compound semiconductor solar battery.

As such, studies have been done on a method for growing compound semiconductor layers having a lattice constant similar to that of a semiconductor substrate on the semiconductor substrate such that a light-receiving surface of a compound semiconductor solar battery is on the semiconductor substrate side, and then growing compound semiconductor layers having a lattice constant different from that of the semiconductor substrate with a buffer layer interposed therebetween (see J. F. Geisz et al., "Inverted GaInP/GaAs/InGaAs triple-junction solar cells with low-stress metamorphic bottom junctions," 33th IEEE Photovoltaic Specialists Conference, 2008 (NPL 1), for example).

That is, a compound semiconductor solar battery is usually formed by growing compound semiconductor layers such that a light-receiving surface is positioned opposite to a semiconductor substrate serving as a growth substrate (i.e., formed such that the light-receiving surface is positioned in a growth direction of the compound semiconductor layers). By growing compound semiconductor layers such that a light-receiving surface is on the semiconductor substrate side, however, good crystallinity is obtained in a compound semiconductor photoelectric conversion cell including the compound semiconductor layers having a lattice constant similar to that of the semiconductor substrate, and the characteristics of a compound semiconductor photoelectric conversion cell including lattice-mismatched compound semiconductor layers having a lattice constant different from that of the semiconductor substrate are also obtained, thereby achieving a highly efficient compound semiconductor solar battery.

CITATION LIST

NON-PATENT LITERATURE

NPL 1: J. F. Geisz et al., "Inverted GaInP/GaAs/InGaAs triple-junction solar cells with low-stress metamorphic bottom junctions," 33th IEEE Photovoltaic Specialists Conference, 2008

SUMMARY OF INVENTION

TECHNICAL PROBLEM

It is desired, however, to make a compound semiconductor solar battery of better performance than the compound semiconductor solar battery made by the method described in NPL 1 mentioned above.

In view of the above circumstances, an object of the present invention is to provide a compound semiconductor solar battery of excellent performance and a method for manufacturing the compound semiconductor solar battery.

SOLUTION TO PROBLEM

The present invention is directed to a compound semiconductor solar battery including a first compound semiconductor photoelectric conversion cell, a second compound semiconductor photoelectric conversion cell provided on the first compound semiconductor photoelectric conversion cell, and a compound semiconductor buffer layer provided between the first compound semiconductor photoelectric conversion cell and the second compound semiconductor photoelectric conversion cell, the first compound semiconductor photoelectric conversion cell and the compound semiconductor buffer layer being provided adjacent to each other, and a ratio of a difference in lattice constant between the first compound semiconductor photoelectric conversion cell and a compound semiconductor layer provided in a position closest to the first compound semiconductor photoelectric conversion cell among compound semiconductor layers constituting the compound semiconductor buffer layer being not less than 0.15% and not more than 0.74%. The present invention is also directed to a compound semiconductor solar battery including a first compound semiconductor photoelectric conversion cell, a second compound semiconductor photoelectric conversion cell, and a compound semiconductor buffer layer provided between the first compound semiconductor photoelectric conversion cell and the second compound semiconductor photoelectric conversion cell, the compound semiconductor buffer layer having a lattice constant increasing from the second compound semiconductor photoelectric conversion cell toward the first compound semiconductor photoelectric conversion cell, the first compound semiconductor photoelectric conversion cell having a lattice constant smaller than a lattice constant of a compound semiconductor layer provided in a position closest to the first compound semiconductor photoelectric conversion cell in the compound semiconductor buffer layer, and a ratio of a difference in lattice constant between the first compound semiconductor photoelectric conversion cell and the compound semiconductor layer provided in the position closest to the first compound semiconductor photoelectric conversion cell in the compound semiconductor buffer layer being not less than 0.15%. Preferably, the ratio of the difference in lattice constant between the first compound semiconductor photoelectric conversion cell and the compound semiconductor layer provided in the position closest to the first compound semiconductor photoelectric conversion cell in the compound semiconductor buffer layer is not more than 0.74%.

Preferably, in the compound semiconductor solar battery according to the present invention, a ratio of a difference in lattice constant between a base layer among compound semiconductor layers constituting the first compound semiconductor photoelectric conversion cell and the compound semiconductor layer provided in the position closest to the first compound semiconductor photoelectric conversion cell among the compound semiconductor layers constituting the compound semiconductor buffer layer is not less than 0.15% and not more than 0.74%.

Preferably, in the compound semiconductor solar battery according to the present invention, a compound semiconductor constituting the first compound semiconductor photoelectric conversion cell has band gap energy of not less than 0.9 eV and not more than 1.1 eV.

Preferably, in the compound semiconductor solar battery according to the present invention, a compound semiconductor constituting the first compound semiconductor photoelectric conversion cell includes InGaAs. When the compound semiconductor constituting the first compound semiconductor photoelectric conversion cell includes InGaAs, a composition ratio among In (Indium), Ga (gallium) and As (arsenic) is not particularly limited but can be set as appropriate.

Preferably, in the compound semiconductor solar battery according to the present invention, a compound semiconductor constituting the second compound semiconductor photoelectric conversion cell includes one of GaAs and InGaAs. When the compound semiconductor constituting the second compound semiconductor photoelectric conversion cell includes GaAs, a composition ratio between Ga and As is not particularly limited but can be set as appropriate. When the compound semiconductor constituting the second compound semiconductor photoelectric conversion cell includes InGaAs, a composition ratio among In, Ga and As is not particularly limited but can be set as appropriate.

Preferably, the compound semiconductor solar battery according to the present invention further includes a third compound semiconductor photoelectric conversion cell provided on the second compound semiconductor photoelectric conversion cell. Preferably, a compound semiconductor constituting the third compound semiconductor photoelectric conversion cell includes one of InGaP and AlInGap. When the compound semiconductor constituting the third compound semiconductor photoelectric conversion cell includes InGaP, a composition ratio among In, Ga and P (phosphor) is not particularly limited but can be set as appropriate. When the compound semiconductor constituting the third compound semiconductor photoelectric conversion cell includes AlInGaP, a composition ratio among Al, In, Ga and P is not particularly limited but can be set as appropriate.

The present invention is also directed to a method for manufacturing one of the compound semiconductor solar batteries described above, including the steps of forming the second compound semiconductor photoelectric conversion cell on a semiconductor substrate, forming the compound semiconductor buffer layer on the second compound semiconductor photoelectric conversion cell, and forming the first compound semiconductor photoelectric conversion cell on the compound semiconductor buffer layer.

The present invention is also directed to a method for manufacturing one of the compound semiconductor solar batteries described above, including the steps of forming the third compound semiconductor photoelectric conversion cell on a semiconductor substrate, forming the second compound semiconductor photoelectric conversion cell on the third compound semiconductor photoelectric conversion cell, forming the compound semiconductor buffer layer on the second compound semiconductor photoelectric conversion cell, and forming the first compound semiconductor photoelectric conversion cell on the compound semiconductor buffer layer.

The present invention is also directed to method for manufacturing the compound semiconductor solar battery described above, including the steps of forming the third compound semiconductor photoelectric conversion cell on a semiconductor substrate by epitaxial growth, forming a first tunnel junction layer on the third compound semiconductor photoelectric conversion cell by epitaxial growth, forming the second compound semiconductor photoelectric conversion cell on the first tunnel junction layer by epitaxial growth, forming a second tunnel junction layer on the second compound semiconductor photoelectric conversion cell by epitaxial growth, forming the compound semiconductor buffer layer on the second tunnel junction layer by epitaxial growth, and forming the first compound semiconductor photoelectric conversion cell on the compound semiconductor buffer layer by epitaxial growth.

Preferably, the method for manufacturing the compound semiconductor solar battery according to the present invention further includes the step of removing the semiconductor substrate.

ADVANTAGEOUS EFFECTS OF INVENTION

According to the present invention, a compound semiconductor solar battery of excellent performance and a method for manufacturing the compound semiconductor solar battery can be provided.

BRIEF DESCRIPTION OF DRAWINGS

Fig. 1 is a schematic cross-sectional structure diagram of an example of a compound semiconductor solar battery according to the present invention.

Fig. 2 is a schematic cross-sectional structure diagram illustrating part of a manufacturing process of an example of a method for manufacturing the compound semiconductor solar battery shown in Fig. 1.

Fig. 3 is a schematic cross-sectional structure diagram illustrating another part of the manufacturing process of the example of the method for manufacturing the compound semiconductor solar battery shown in Fig. 1.

Fig. 4 is a schematic cross-sectional structure diagram illustrating yet another part of the manufacturing process of the example of the method for manufacturing the compound semiconductor solar battery shown in Fig. 1.

Fig. 5 is a schematic cross-sectional structure diagram of another example of the compound semiconductor solar battery according to the present invention.

Fig. 6 is a schematic cross-sectional structure diagram illustrating part of a manufacturing process of an example of a method for manufacturing the compound semiconductor solar battery shown in Fig. 5.

Fig. 7 is a schematic cross-sectional structure diagram illustrating another part of the manufacturing process of the example of the method for manufacturing the compound semiconductor solar battery shown in Fig. 5.

Fig. 8 is a schematic cross-sectional structure diagram illustrating yet another part of the manufacturing process of the example of the method for manufacturing the compound semiconductor solar battery shown in Fig. 5.

Fig. 9 is a schematic cross-sectional structure diagram of yet another example of the compound semiconductor solar battery according to the present invention.

Fig. 10 is a schematic cross-sectional structure diagram illustrating part of a manufacturing process of an example of a method for manufacturing the compound semiconductor solar battery shown in Fig. 9.

Fig. 11 is a schematic cross-sectional structure diagram illustrating another part of the manufacturing process of the example of the method for manufacturing the compound semiconductor solar battery shown in Fig. 9.

Fig. 12 is a schematic cross-sectional structure diagram illustrating yet another part of the manufacturing process of the example of the method for manufacturing the compound semiconductor solar battery shown in Fig. 9.

Fig. 13 is a schematic cross-sectional structure diagram of yet another example of the compound semiconductor solar battery according to the present invention.

Fig. 14 is a schematic cross-sectional structure diagram illustrating part of a manufacturing process of an example of a method for manufacturing the compound semiconductor solar battery shown in Fig. 13.

Fig. 15 is a schematic cross-sectional structure diagram illustrating another part of the manufacturing process of the example of the method for manufacturing the compound semiconductor solar battery shown in Fig. 13.

Fig. 16 is a schematic cross-sectional structure diagram illustrating yet another part of the manufacturing process of the example of the method for manufacturing the compound semiconductor solar battery shown in Fig. 13.

Fig. 17 is a schematic cross-sectional view of samples No. 1 to No. 7 which were made in an example.

Fig. 18 illustrates relation between a band gap Eg of a base layer and an open-circuit voltage Voc of a bottom cell in each of the samples No. 1 to No. 7 which were made in the example.

Fig. 19 illustrates relation between a voltage and a current density (current-voltage characteristics) of the bottom cell in each of the samples No. 1 to No. 7 which were made in the example.

DESCRIPTION OF EMBODIMENTS

Embodiments of the present invention will be described hereinafter. It is noted that the same or corresponding parts have the same reference marks allotted in the drawings of the present invention.

<First Embodiment>

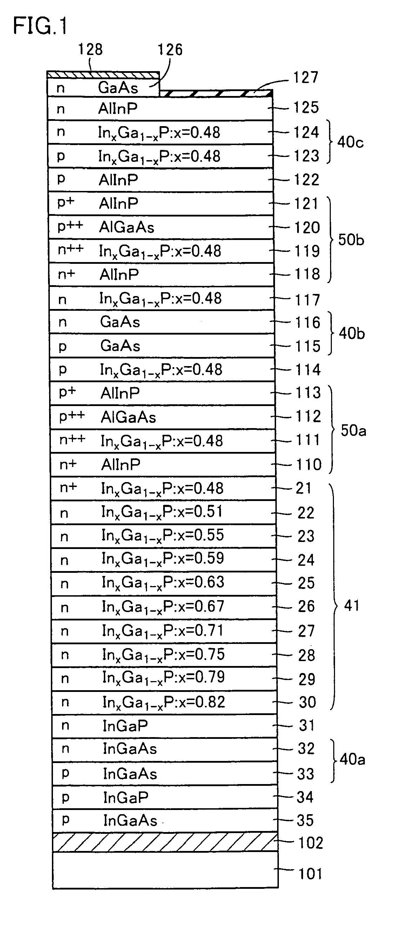

Fig. 1 is a schematic cross-sectional structure diagram of an example of a compound semiconductor solar battery according to the present invention. In this compound semiconductor solar battery, on a support substrate 101 (e.g. 400 $\mu$m thick), metal layer 102, a contact layer 35 made of p type InGaAs (e.g. 0.4 $\mu$m thick), a BSF layer 34 made of p type InGaP (e.g. 0.1 $\mu$m thick), a base layer 33 made of p type InGaAs (e.g. 3 $\mu$m thick), an emitter layer 32 made of n type InGaAs (e.g. 0.1 $\mu$m thick), and a window layer 31 made of n type InGaP (e.g. 0.1 $\mu$m thick) are stacked in this order. Base layer 33 made of p type InGaAs and emitter layer 32 made of n type InGaAs joined to each other constitute a bottom cell 40a. Window layer 31 made of n type InGaP and emitter layer 32 made of n type InGaAs each have a lattice constant similar to that of base layer 33 made of p type InGaAs.

On window layer 31 made of n type InGaP, an n type $In_{0.82}Ga_{0.18}P$ layer 30 (e.g. 1 $\mu$m thick), an n type $In_{0.79}Ga_{0.21}P$ layer 29 (e.g. 0.25 $\mu$m thick), an n type $In_{0.75}Ga_{0.25}P$ layer 28 (e.g. 0.25 $\mu$m thick), an n type $In_{0.71}Ga_{0.29}P$ layer 27 (e.g. 0.25 $\mu$m thick), an n type $In_{0.67}Ga_{0.33}P$ layer 26 (e.g. 0.25 $\mu$m thick), an n type $In_{0.63}Ga_{0.37}P$ layer 25 (e.g. 0.25 $\mu$m thick), an n type $In_{0.59}Ga_{0.41}P$ layer 24 (e.g. 0.25 $\mu$m thick), an n type $In_{0.55}Ga_{0.45}P$ layer 23 (e.g. 0.25 $\mu$m thick), an n type $In_{0.51}Ga_{0.49}P$ layer 22 (e.g. 0.25 $\mu$m thick), and an n+ type $In_{0.48}Ga_{0.52}P$ layer 21 (e.g. 0.25 $\mu$m thick) are stacked in this order. N type $In_{0.82}Ga_{0.18}P$ layer 30, n type $In_{0.79}Ga_{0.21}P$ layer 29, n type $In_{0.75}Ga_{0.25}$ layer 28, n type $In_{0.71}Ga_{0.29}P$ layer 27, n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 constitute a buffer layer 41.

On buffer layer 41, an n+ type AlInP layer 110 (e.g. 0.05 $\mu$m thick), an n++ type $In_{0.48}Ga_{0.52}P$ layer 111 (e.g. 0.02 $\mu$m thick), a p++ type AlGaAs layer 112 (e.g. 0.02 $\mu$m thick), and a p+ type AlInP layer 113 (e.g. 0.05 $\mu$m thick) are stacked in this order. N+ type AlInP layer 110, n++ type $In_{0.48}Ga_{0.52}P$ layer 111, p++ type AlGaAs layer 112, and p+ type AlInP layer 113 constitute a tunnel junction layer 50a.

On tunnel junction layer 50a, a BSF layer 114 made of p type $In_{0.48}Ga_{0.52}P$ (e.g. 0.1 $\mu$m thick), a base layer 115 made of p type.GaAs (e.g. 3 $\mu$m thick), an emitter layer 116 made of n type GaAs (e.g. 0.1 $\mu$m thick), and a window layer 117 made of n type $In_{0.48}Ga_{0.52}P$ (e.g. 0.1 $\mu$m thick) are stacked in this order. Base layer 115 made of p type GaAs and emitter layer 116 made of n type GaAs joined to each other constitute a middle cell 40b.

On window layer 117 made of n type $In_{0.48}Ga_{0.52}P$, an n+ type AlInP layer 118 (e.g. 0.05 $\mu$m thick), an n++ type $In_{0.48}Ga_{0.52}P$ layer 119 (e.g. 0.02 $\mu$m thick), a p++ type AlGaAs layer 120 (e.g. 0.02 $\mu$m thick), and a p+ type AlInP layer 121 (e.g. 0.05 $\mu$m thick) are stacked in this order. N+ type AlInP layer 118, n++ type $In_{0.48}Ga_{0.52}P$ layer 119, p++ type AlGaAs layer 120, and p+ type AlInP layer 121 constitute a tunnel junction layer 50b.

On p+ type AlInP layer 121, a BSF layer 122 made of p type AlInP (e.g. 0.05 $\mu$m thick), a base layer 123 made ofp type $In_{0.48}Ga_{0.52}P$ (e.g. 0.65 $\mu$m thick), an emitter layer 124 made of n type $In_{0.48}Ga_{0.52}P$ (e.g. 0.05 $\mu$m thick), and a window layer 125 made of n type AlInP (e.g. 0.05 $\mu$m thick) are stacked in this order. Base layer 123 made of p type $In_{0.48}Ga_{0.52}P$ and emitter layer 124 made of n type $In_{0.48}Ga_{0.52}P$ joined to each other constitute a top cell 40c.

On window layer 125 made of n type AlInP, a contact layer 126 made of n type GaAs (e.g. 0.4 $\mu$m thick) and an antireflection film 127 are formed, and an electrode layer 128 is formed on contact layer 126.

In the compound semiconductor solar battery shown in Fig. 1, a band gap increases in the order of the compound semiconductor layers constituting bottom cell 40a, the compound semiconductor layers constituting middle cell 40b, and the compound semiconductor layers constituting top cell 40c.

It is preferable that the compound semiconductor layers constituting bottom cell 40a have band gap energy of not less than 0.9 eV and not more than 1.1 eV. In this case, theoretical efficiency of the compound semiconductor solar battery having a three-junction structure including top cell 40c, middle cell 40b and bottom cell 40a tends to be not less than 45%.

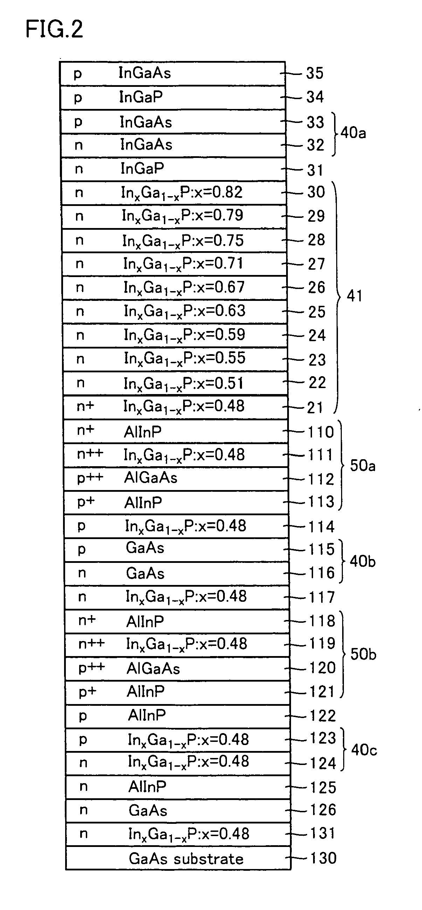

Referring to cross-sectional structure diagrams in Figs. 2 to 4, an example of a method for manufacturing the compound semiconductor solar battery having the structure shown in Fig. 1 will be described.

First, as shown in Fig. 2, a GaAs substrate 130 having a diameter of 50 mm, for example, is placed in an MOCVD (Metal Organic Chemical Vapor Deposition) device, and on GaAs substrate 130, an etching stop layer 131 made of n type $In_{0.48}Ga_{0.52}P$ to be an etching stop layer that can be selectively etched with GaAs, contact layer 126 made of n type GaAs, window layer 125 made of n type AlInP, emitter layer 124 made of n type $In_{0.48}Ga_{0.52}P$, base layer 123 made of p type $In_{0.48}Ga_{0.52}P$, and BSF layer 122 made of p type AlInP are epitaxially grown in this order by MOCVD.

Next, on BSF layer 122 made of p type AlInP, p+ type AlInP layer 121, p++ type AlGaAs layer 120, n++ type $In_{0.48}Ga_{0.52}P$ layer 119, and n+ type AlInP layer 118 are epitaxially grown in this order by MOCVD.

Next, on n+ type AlInP layer 118, window layer 117 made of n type $In_{0.48}Ga_{0.52}P$, emitter layer 116 made of n type GaAs, base layer 115 made of p type GaAs, and BSF layer 114 made of p type $In_{0.48}Ga_{0.52}P$ are epitaxially grown in this order by MOCVD.

Next, on BSF layer 114 made of p type $In_{0.48}Ga_{0.52}P$, p+ type AlInP layer 113, p++ type AlGaAs layer 112, n++ type $In_{0.48}Ga_{0.52}P$ layer 111, and n+ type AlInP layer 110 are epitaxially grown in this order by MOCVD.

Next, on n+ type AlInP layer 110, n+ type $In_{0.48}Ga_{0.52}P$ layer 21, n type $In_{0.51}Ga_{0.49}P$ layer 22, n type $In_{0.55}Ga_{0.45}P$ layer 23, n type $In_{0.59}Ga_{0.41}P$ layer 24, n type $In_{0.63}Ga_{0.37}P$ layer 25, n type $In_{0.67}Ga_{0.33}P$ layer 26, n type $In_{0.71}Ga_{0.29}P$ layer 27, n type $In_{0.75}Ga_{0.25}P$ layer 28, n type $In_{0.79}Ga_{0.21}P$ layer 29, and n type $In_{0.82}Ga_{0.18}P$ layer 30 are epitaxially grown by MOCVD.

Next, on n type $In_{0.82}Ga_{0.18}P$ layer 30, n type InGaP layer 31, emitter layer 32 made of n type InGaAs, base layer 33 made of p type InGaAs, BSF layer 34 made of p type InGaP, and contact layer 35 made of p type InGaAs are epitaxially grown in this order by MOCVD.

Here, $AsH_3$ (arsine) and TMG (trimethylgallium) can be used to form GaAs, TMI (trimethylindium), TMG and $PH_3$ (phosphine) can be used to form InGaP, TMI, TMG and $AsH_3$ can be used to form InGaAs, TMA (trimethylaluminum), TMI and $PH_3$ can be used to form AlInP, TMA, TMG and $AsH_3$ can be used to form AlGaAs, and TMA, TMI, TMG and $AsH_3$ can be used to form AlInGaAs.

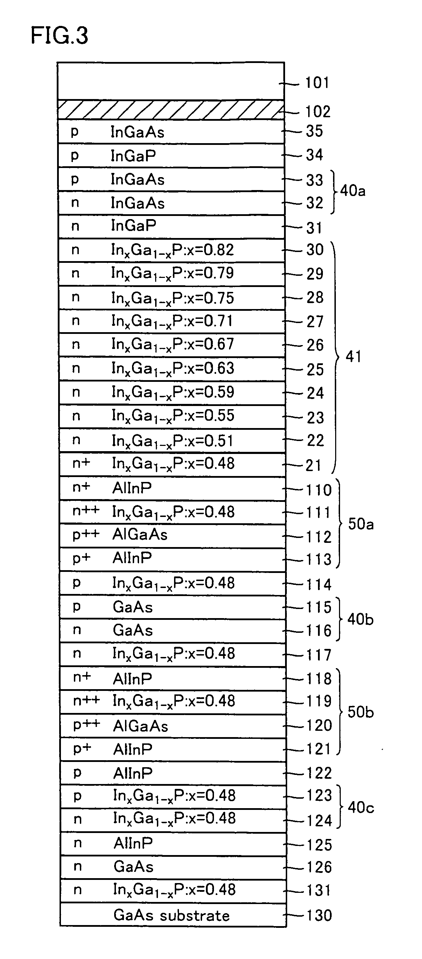

Then, as shown in Fig. 3, support substrate 101 is attached to a surface of contact layer 35 made of p type InGaAs via metal layer 102 formed of a stacked body including Au (e.g. 0.1 μm thick)/Ag (e.g. 3 μm thick), for example.

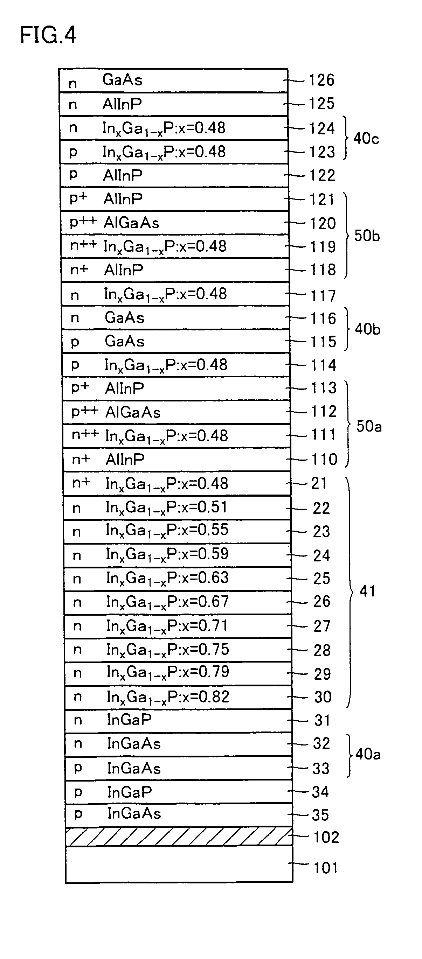

Next, as shown in Fig. 4, GaAs substrate 130 is etched with an alkaline aqueous solution, and then etching stop layer 131 made of n type $In_{0.48}Ga_{0.52}P$ is etched with an acid solution.

Next, a resist pattern is formed by photolithography on contact layer 126 made of n type GaAs, and then contact layer 126 is partially removed by etching with an alkaline aqueous solution. Then, a resist pattern is formed by photolithography again on a surface of remaining contact layer 126, and electrode layer 128 formed of a stacked body including AuGe (12%) (e.g. 0.1 μm thick)/Ni (e.g. 0.02 μm thick)/Au (e.g. 0.1 μm thick)/Ag (e.g. 5 μm thick), for example, is formed using a resistance heating evaporation device and an EB (Electron Beam) evaporation device.

Next, a mesa etching pattern is formed, and then mesa etching is performed with an alkaline aqueous solution and an acid solution. Then, a stacked body including a $TiO_2$ film (e.g. 55 nm thick) and an $Al_2O_3$ film (e.g. 85 nm thick), for example, is formed by EB evaporation, to form antireflection film 127. As a result, the compound semiconductor solar battery having the structure shown in Fig. 1 with a light-receiving surface positioned opposite to a growth direction of the compound semiconductor can be obtained.

In the compound semiconductor solar battery having the structure shown in Fig. 1, buffer layer 41 is provided between bottom cell 40a and middle cell 40b. Bottom cell 40a and buffer layer 41 are arranged adjacent to and in contact with each other, and a ratio of a difference in lattice constant between base layer 33 made of p type InGaAs among the compound semiconductor layers constituting bottom cell 40a and n type $In_{0.82}Ga_{0.18}P$ layer 30 arranged in a position closest to bottom cell 40a among the compound semiconductor layers constituting buffer layer 41 is not less than 0.15% and not more than 0.74%.

This is based on dedicated studies by the present inventors, which found that the performance of the compound semiconductor solar battery can be improved as will be described later, if the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is in the range of not less than 0.15% and not more than 0.74%.

A ratio of a difference in lattice constant (%) can be calculated by the following equation (1):

$$\text{Ratio of difference in lattice constant (\%)} = (100 \times (a1 - a2)) / (a1) \ldots (1)$$

In the above equation (1), a1 represents a lattice constant of a compound semiconductor layer (n type $In_{0.82}Ga_{0.18}P$ layer 30 in this embodiment) provided in a position closest to a bottom cell among compound semiconductor layers constituting a buffer layer.

In the above equation (1), a2 represents a lattice constant of a compound semiconductor layer (base layer 33 made of p type InGaAs in this embodiment) serving as a base layer among compound semiconductor layers constituting a bottom cell.

In this embodiment, the ratio of the difference in lattice constant is adjusted to be in the above range by adjustment of the composition of base layer 33 made of p type InGaAs constituting bottom cell 40a. Alternatively, the above ratio of the difference in lattice constant can be adjusted to be in the range of not less than 0.15% and not more than 0.74% by adjustment of the composition of at least one of the base layer among the compound semiconductor layers constituting bottom cell 40a and the compound semiconductor layer arranged in the position closest to bottom cell 40a among the compound semiconductor layers constituting buffer layer 41.

It is preferable that the above ratio of the difference in lattice constant be in a range of not less than 0.3% and not more than 0.5%. When the above ratio of the difference in lattice constant is in the range of not less than 0.3% and not more than 0.5%, the performance of the compound semiconductor solar battery tends to be further improved.

In addition, since emitter layer 32 and window layer 31 each have a very small thickness compared to those of base layer 33 and n type $In_{0.82}Ga_{0.18}P$ layer 30, it is considered that the presence or absence of emitter layer 32 and window layer 31 has little effect on the above ratio of the difference in lattice constant.

In the present specification, when a composition ratio of elements constituting a compound is not described in a chemical formula of the compound and their compositions are not particularly mentioned, the composition ratio shall not be particularly limited but can be set as appropriate.

Moreover, in the present specification, when a composition ratio of elements constituting a compound is described in a chemical formula of the compound, the present invention shall not be limited to a compound having that composition ratio.

<Second Embodiment>

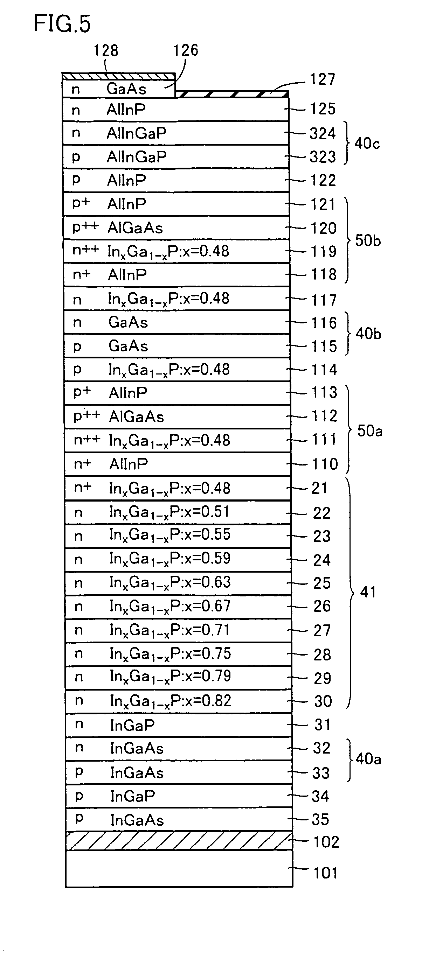

Fig. 5 is a schematic cross-sectional structure diagram of another example of the compound semiconductor solar battery according to the present invention. In the compound semiconductor solar battery having the structure shown in Fig. 5, an emitter layer 324 made of n type AlInGaP and a base layer 323 made of p type AlInGaP joined to each other constitute top cell 40c.

In the compound semiconductor solar battery having the structure shown in Fig. 5, on support substrate 101, metal layer 102, contact layer 35 made of p type InGaAs, BSF layer 34 made of p type InGaP, base layer 33 made of p type InGaAs, emitter layer 32 made of n type InGaAs, and window layer 31 made of n type InGaP are stacked in this order. Base layer 33 made of p type InGaAs and emitter layer 32 made of n type InGaAs joined to each other constitute bottom cell 40a.

On window layer 31 made of n type InGaP, n type $In_{0.82}Ga_{0.18}P$ layer 30, n type $In_{0.79}Ga_{0.21}P$ layer 29, n type $In_{0.75}Ga_{0.25}P$ layer 28, n type $In_{0.71}Ga_{0.29}P$ layer 27, n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 are stacked in this order. N type $In_{0.82}Ga_{0.18}P$ layer 30, n type $In_{0.79}Ga_{0.21}P$ layer 29, n type $In_{0.75}Ga_{0.25}P$ layer 28, n type $In_{0.71}Ga_{0.29}P$ layer 27, n type $In_{0.67}Ga_{0.33}P$ layer 26, n type $In_{0.63}Ga_{0.37}P$ layer 25, n type $In_{0.59}G_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 constitute buffer layer 41.

On buffer layer 41, n+ type AlInP layer 110, n++ type $In_{0.48}Ga_{0.52}P$ layer 111, p++ type AlGaAs layer 112, and p+ type AlInP layer 113 are stacked in this order. N+ type AlInP layer 110, n++ type $In_{0.48}Ga_{0.52}P$ layer 111, p++ type AlGaAs layer 112, and p+ type AlInP layer 113 constitute tunnel junction layer 50a.

On tunnel junction layer 50a, BSF layer 114 made of p type $In_{0.48}Ga_{0.52}P$, base layer 115 made of p type GaAs, emitter layer 116 made of n type GaAs, and window layer 117 made of n type $In_{0.48}Ga_{0.52}P$ are stacked in this order. Base layer 115 made of p type GaAs and emitter layer 116 made of n type GaAs joined to each other constitute middle cell 40b.

On window layer 117 made of n type $In_{0.48}Ga_{0.52}P$, n+ type AlInP layer 118, n++ type $In_{0.48}Ga_{0.52}P$ layer 119, p++ type AlGaAs layer 120, and p+ type AlInP layer 121 are stacked in this order. N+ type AlInP layer 118, n++ type $In_{0.48}Ga_{0.52}P$ layer 119, p++ type AlGaAs layer 120, and p+ type AlInP layer 121 constitute tunnel junction layer 50b.

On p+ type AlInP layer 121, BSF layer 122 made of p type AlInP, base layer 323 made of p type AlInGaP (e.g. 3 μm thick), emitter layer 324 made of n type AlInGaP (e.g. 0.1 μm thick), and window layer 125 made of n type AlInP are stacked in this order. Base layer 323 made of p type AlInGaP and emitter layer 324 made of n type AlInGaP joined to each other constitute top cell 40c.

On window layer 125 made of n type AlInP, contact layer 126 made of n type GaAs and antireflection film 127 are formed, and electrode layer 128 is formed on contact layer 126.

In the compound semiconductor solar battery shown in Fig. 5, a band gap increases in the order of the compound semiconductor layers constituting bottom cell 40a, the compound semiconductor layers constituting middle cell 40b, and the compound semiconductor layers constituting top cell 40c.

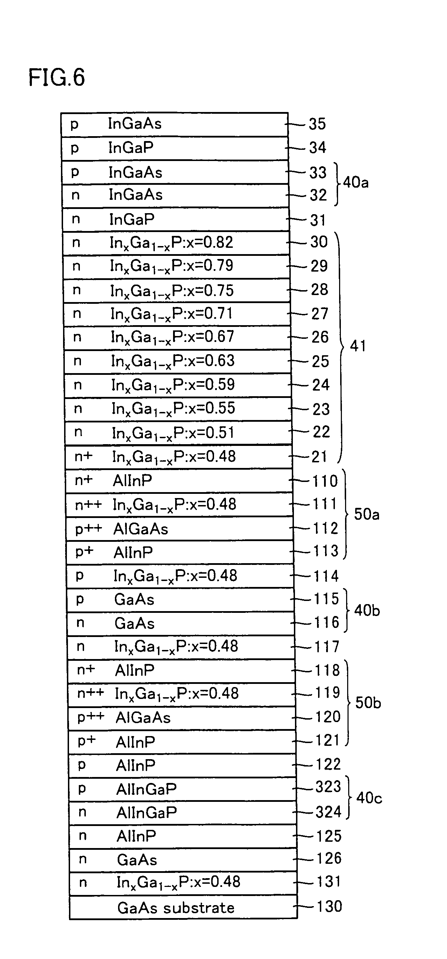

Referring to cross-sectional structure diagrams in Figs. 6 to 8, an example of a method for manufacturing the compound semiconductor solar battery having the structure shown in Fig. 5 will be described.

First, as shown in Fig. 6, GaAs substrate 130 having a diameter of 50 mm, for example, is placed in an MOCVD (Metal Organic Chemical Vapor Deposition) device, and on GaAs substrate 130, etching stop layer 131 made of n type $In_{0.48}Ga_{0.52}P$ to be an etching stop layer that can be selectively etched with GaAs, contact layer 126 made of n type GaAs, window layer 125 made of n type AlInP, emitter layer 324 made of n type AlInGaP, base layer 323 made of p type AlInGaP, and BSF layer 122 made of p type AlInP are epitaxially grown in this order by MOCVD.

Next, on BSF layer 122 made of p type AlInP, p+ type AlInP layer 121, p++ type AlGaAs layer 120, n++ type $In_{0.48}Ga_{0.52}P$ layer 119, and n+ type AlInP layer 118 are epitaxially grown in this order by MOCVD.

Next, on n+ type AlInP layer 118, window layer 117 made of n type $In_{0.48}Ga_{0.52}P$, emitter layer 116 made of n type GaAs, base layer 115 made of p type GaAs, and BSF layer 114 made of p type $In_{0.48}Ga_{0.52}P$ are epitaxially grown in this order by MOCVD.

Next, on BSF layer 114 made of p type $In_{0.48}Ga_{0.52}P$, p+ type AlInP layer 113, p++ type AlGaAs layer 112, n++ type $In_{0.48}Ga_{0.52}P$ layer 111, and n+ type AlInP layer 110 are epitaxially grown in this order by MOCVD.

Next, on n+ type AlInP layer 110, n+ type $In_{0.48}Ga_{0.52}P$ layer 21, n type $In_{0.51}Ga_{0.49}P$ layer 22, n type $In_{0.55}Ga_{0.45}P$ layer 23, n type $In_{0.59}Ga_{0.41}P$ layer 24, n type $In_{0.63}Ga_{0.37}P$ layer 25, n type $In_{0.67}Ga_{0.33}P$ layer 26, n type $In_{0.7}Ga_{0.29}P$ layer 27, n type $In_{0.75}Ga_{0.25}P$ layer 28, n type $In_{0.79}Ga_{0.21}P$ layer 29, and n type $In_{0.82}Ga_{0.18}P$ layer 30 are epitaxially grown by MOCVD.

Next, on n type $In_{0.82}Ga_{0.18}P$ layer 30, n type InGaP layer 31, emitter layer 32 made of n type InGaAs, base layer 33 made of p type InGaAs, BSF layer 34 made of p type InGaP, and contact layer 35 made of p type InGaAs are epitaxially grown in this order by MOCVD.

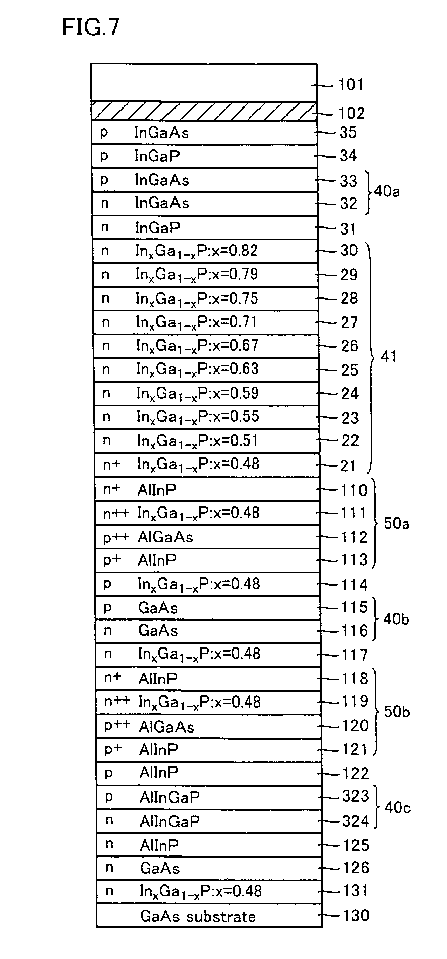

Then, as shown in Fig. 7, support substrate 101 is attached to a surface of contact layer 35 made of p type InGaAs via metal layer 102 formed of a stacked body including Au (e.g. 0.1 $\mu$m thick)/Ag (e.g. 3 $\mu$m thick), for example.

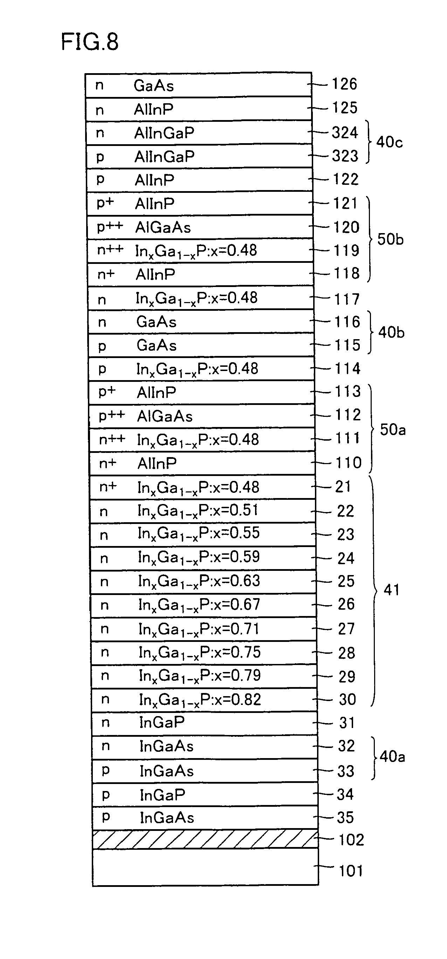

Next, as shown in Fig. 8, GaAs substrate 130 is etched with an alkaline aqueous solution, and then etching stop layer 131 made of n type $In_{0.48}Ga_{0.52}P$ is etched with an acid solution.

Next, a resist pattern is formed by photolithography on contact layer 126 made of n type GaAs, and then contact layer 126 is partially removed by etching with an alkaline aqueous solution. Then, a resist pattern is formed by photolithography again on a surface of remaining contact layer 126, and electrode layer 128 formed of a stacked body including AuGe (12%) (e.g. 0.1 $\mu$m thick)/Ni (e.g. 0.02 $\mu$m thick)/Au (e.g. 0.1 $\mu$m thick)/Ag (e.g. 5 $\mu$m thick), for example, is formed using a resistance heating evaporation device and an EB (Electron Beam) evaporation device.

Next, a mesa etching pattern is formed, and then mesa etching is performed with an alkaline aqueous solution and an acid solution. Then, a stacked body including a $TiO_2$ film (e.g. 55 nm thick) and an $Al_2O_3$ film (e.g. 85 nm thick), for example, is formed by EB evaporation, to form antireflection film 127. As a result, the compound semiconductor solar battery having the structure shown in Fig. 5 with a light-receiving surface positioned opposite to a growth direction of the compound semiconductor can be obtained.

In the compound semiconductor solar battery having the structure shown in Fig. 5, buffer layer 41 is provided between bottom cell 40a and middle cell 40b. Bottom cell 40a and buffer layer 41 are arranged adjacent to and in contact with each other, and the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is not less than 0.15% and not more than 0.74%, preferably not less than 0.3% and not more than 0.5%.

Thus, between bottom cell 40a and buffer layer 41 adjacent to each other in the compound semiconductor solar battery having the structure shown in Fig. 5, the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is again not less than 0.15% and not more than 0.74%, preferably not less than 0.3% and not more than 0.5%. Therefore, the compound semiconductor solar battery can have improved performance as will be described later.

This embodiment is similar to the first embodiment except for the above description, and thus the description thereof will not be repeated.

<Third Embodiment>

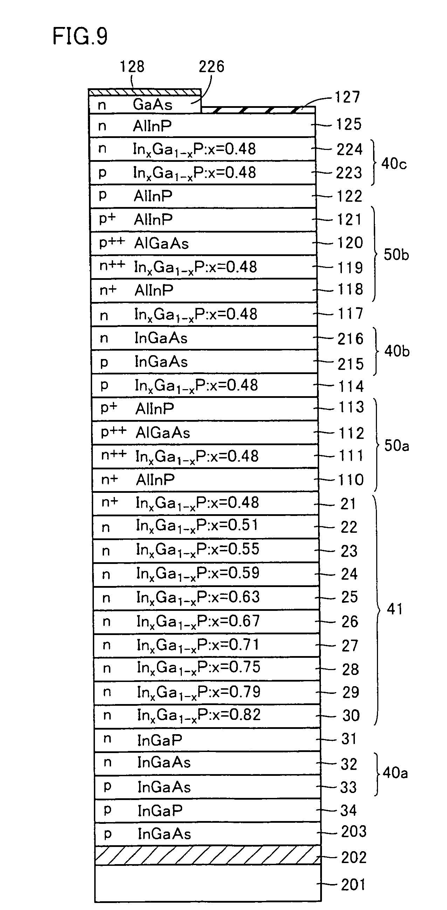

Fig. 9 is a schematic cross-sectional structure diagram of another example of the compound semiconductor solar battery according to the present invention. The compound semiconductor solar battery having the structure shown in Fig. 9 is formed by growing compound semiconductor layers on a p type Ge substrate.

In the compound semiconductor solar battery having the structure shown in Fig. 9, on a support substrate 201 (e.g. 400 $\mu$m thick), a metal layer 202, a contact layer 203 made of p type InGaAs (e.g. 0.4 $\mu$m thick), BSF layer 34 made of p type InGaP, base layer 33 made of p type InGaAs, emitter layer 32 made of n type InGaAs, and window layer 31 made of n type InGaP are stacked in this order. Base layer 33 made of p type InGaAs and emitter layer 32 made of n type InGaAs joined to each other constitute bottom cell 40a.

On window layer 31 made of n type InGaP, n type $In_{0.82}Ca_{0.18}P$ layer 30, n type $In_{0.79}Ga_{0.21}P$ layer 29, n type $In_{0.75}Ga_{0.25}P$ layer 28, n type $In_{0.71}Ga_{0.29}P$ layer 27, n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 are stacked in this order. N type $In_{0.82}Ga_{0.18}P$ layer 30, n type $In_{0.79}Ga_{0.21}P$ layer 29, n type $In_{0.75}Ga_{0.25}P$ layer 28, n type $In_{0.71}Ga_{0.29}P$ layer 27, n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 constitute buffer layer 41.

On buffer layer 41, n+ type AlInP layer 110 (e.g. 0.05 μm thick), n++ type $In_{0.48}Ga_{0.52}P$ layer 111 (e.g. 0.02 μm thick), p++ type AlGaAs layer 112 (e.g. 0.02 μm thick), and p+ type AlInP layer 113 (e.g. 0.05 μm thick) are stacked in this order. N+ type AlInP layer 110, n++ type $In_{0.48}Ga_{0.52}P$ layer 111, p++ type AlGaAs layer 112, and p+ type AlInP layer 113 constitute tunnel junction layer 50a.

On tunnel junction layer 50a, BSF layer 114 made of p type $In_{0.48}Ga_{0.52}P$ (e.g. 0.1 μm thick), a base layer 215 made of p type InGaAs (e.g. 3 μm thick), an emitter layer 216 made of n type InGaAs (e.g. 0.1 μm thick), and window layer 117 made of n type $In_{0.48}Ga_{0.52}P$ (e.g. 0.1 μm thick) are stacked in this order. Base layer 215 made of p type InGaAs and emitter layer 216 made of n type InGaAs joined to each other constitute middle cell 40b.

On window layer 117 made of n type $In_{0.48}Ga_{0.52}P$, n+ type AlInP layer 118 (e.g. 0.05 μm thick), n++ type $In_{0.48}Ga_{0.52}P$ layer 119 (e.g. 0.02 μm thick), p++ type AlGaAs layer 120 (e.g. 0.02 μm thick), and p+ type AlInP layer 121 (e.g. 0.05 μm thick) are stacked in this order. N+ type AlInP layer 118, n++ type $In_{0.48}Ga_{0.52}P$ layer 119, p++ type AlGaAs layer 120, and p+ type AlInP layer 121 constitute tunnel junction layer 50b.

On p+ type AlInP layer 121, BSF layer 122 made of p type AlInP (e.g. 0.05 μm thick), a base layer 223 made of p type $In_{0.48}Ga_{0.52}P$ (e.g. 0.65 μm thick), an emitter layer 224 made of n type $In_{0.48}Ga_{0.52}P$ (e.g. 0.05 μm thick), and window layer 125 made of n type AlInP (e.g. 0.05 μm thick) are stacked in this order. Base layer 223 made of p type $In_{0.48}Ga_{0.52}P$ and emitter layer 224 made of n type $In_{0.48}Ga_{0.52}P$ joined to each other constitute top cell 40c.

On window layer 125 made of n type AlInP, a contact layer 226 made of n type GaAs and antireflection film 127 are formed, and electrode layer 128 is formed on contact layer 226.

In the compound semiconductor solar battery shown in Fig. 9, a band gap increases in the order of the compound semiconductor layers constituting bottom cell 40a, the compound semiconductor layers constituting middle cell 40b, and the compound semiconductor layers constituting top cell 40c.

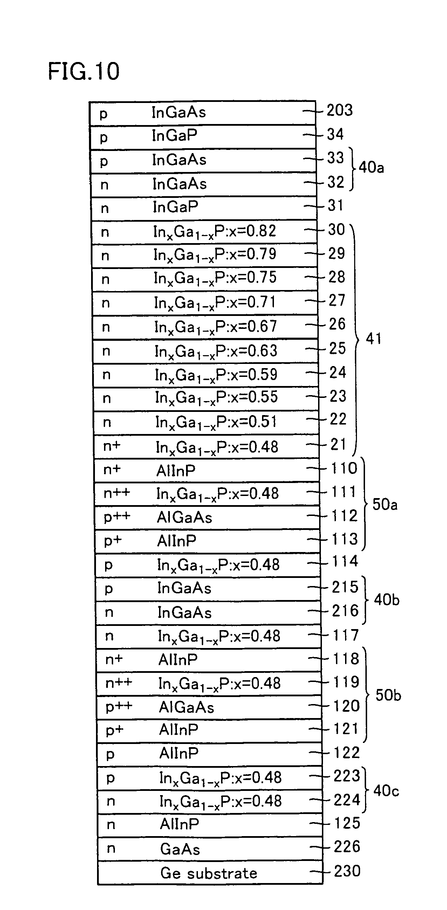

Referring to cross-sectional structure diagrams in Figs. 10 to 12, an example of a method for manufacturing the compound semiconductor solar battery having the structure shown in Fig. 9 will be described.

First, as shown in Fig. 10, a Ge substrate 230 having a diameter of 50 mm, for example, is placed in an MOCVD (Metal Organic Chemical Vapor Deposition) device, and on Ge substrate 230, contact layer 226 made of n type GaAs, window layer 125 made of n type AlInP, emitter layer 224 made of n type $In_{0.48}Ga_{0.52}P$, base layer 223 made of p type $In_{0.48}Ga_{0.52}P$, and BSF layer 122 made of p type AlInP are epitaxially grown in this order by MOCVD.

Next, on BSF layer 122 made of p type AlInP, p+ type AlInP layer 121, p++ type AlGaAs layer 120, n++ type $In_{0.48}Ga_{0.52}P$ layer 119, and n+ type AlInP layer 118 are epitaxially grown in this order by MOCVD.

Next, on n+ type AlInP layer 118, window layer 117 made of n type $In_{0.48}Ga_{0.52}P$, emitter layer 216 made of n type InGaAs, base layer 215 made of p type InGaAs, and BSF layer 114 made of p type $In_{0.48}Ga_{0.52}P$ are epitaxially grown in this order by MOCVD.

Next, on BSF layer 114 made of p type $In_{0.48}Ga_{0.52}P$, p+ type AlInP layer 113, p++ type AlGaAs layer 112, n++ type $In_{0.48}Ga_{0.52}P$ layer 111, and n+ type AlInP layer 110 are epitaxially grown in this order by MOCVD.

Next, on n+ type AlInP layer 110, n+ type $In_{0.48}Ga_{0.52}P$ layer 21, n type $In_{0.51}Ga_{0.49}P$ layer 22, n type $In_{0.55}Ga_{0.45}P$ layer 23, n type $In_{0.59}Ga_{0.41}P$ layer 24, n type $In_{0.63}Ga_{0.37}P$ layer 25, n type $In_{0.67}Ga_{0.33}P$ layer 26, n type $In_{0.71}Ga_{0.29}P$ layer 27, n type $In_{0.75}Ga_{0.25}P$ layer 28, n type $In_{0.79}Ga_{0.21}P$ layer 29, and n type $In_{0.82}Ga_{0.18}P$ layer 30 are epitaxially grown by MOCVD.

Next, on n type $In_{0.82}Ga_{0.18}P$ layer 30, n type InGaP layer 31, emitter layer 32 made of n type InGaAs, base layer 33 made of p type InGaAs, BSF layer 34 made of p type InGaP, and contact layer 203 made of p type InGaAs are epitaxially grown in this order by MOCVD.

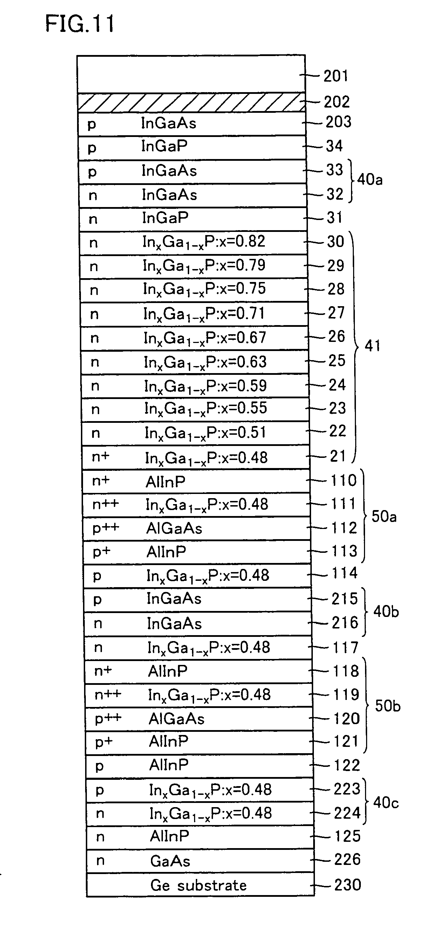

Then, as shown in Fig. 11, support substrate 201 is attached to a surface of contact layer 203 made of p type InGaAs via metal layer 202 formed of a stacked body including Au (e.g. 0.1 μm thick)/Ag (e.g. 3 μm thick), for example.

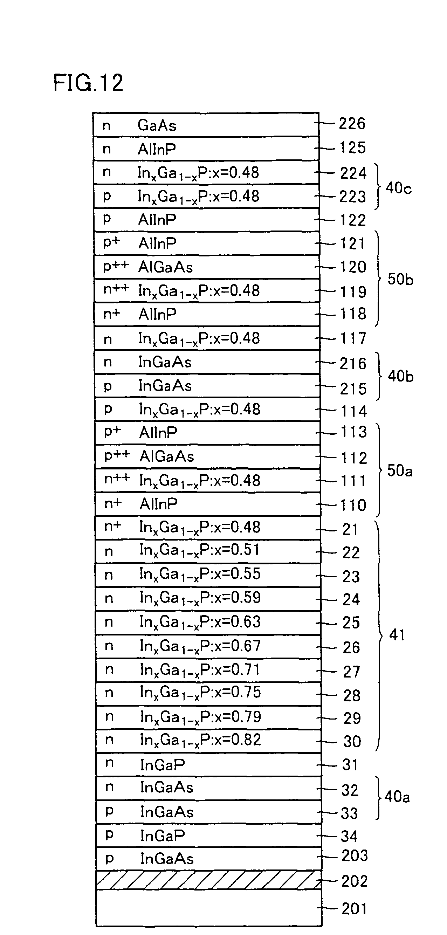

Next, as shown in Fig. 12, Ge substrate 230 is etched with a hydrofluoric aqueous solution.

Next, a resist pattern is formed by photolithography on contact layer 226 made of n type GaAs, and then contact layer 226 is partially removed by etching with an alkaline aqueous solution. Then, a resist pattern is formed by photolithography again on a surface of remaining contact layer 226, and electrode layer 128 formed of a stacked body including AuGe (12%) (e.g. 0.1 μm thick)/Ni (e.g. 0.02 μm thick)/Au (e.g. 0.1 μm thick)/Ag (e.g. 5 μm thick), for example, is formed using a resistance heating evaporation device and an EB (Electron Beam) evaporation device.

Next, a mesa etching pattern is formed, and then mesa etching is performed with an alkaline aqueous solution and an acid solution. Then, a stacked body including a $TiO_2$ film (e.g. 55 nm thick) and an $Al_2O_3$ film (e.g. 85 nm thick), for example, is formed by EB evaporation, to form antireflection film 127. As a result, the compound semiconductor solar battery having the structure shown in Fig. 9 with a light-receiving surface positioned opposite to a growth direction of the compound semiconductor layers can be obtained.

In the compound semiconductor solar battery having the structure shown in Fig. 9, buffer layer 41 is provided between bottom cell 40a and middle cell 40b. Bottom cell 40a and buffer layer 41 are arranged adjacent to and in contact with each other, and the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is not less than 0.15% and not more than 0.74%, preferably not less than 0.3% and not more than 0.5%.

Thus, between bottom cell 40a and buffer layer 41 adjacent to each other in the compound semiconductor solar battery having the structure shown in Fig. 9, the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is again not less than 0.15% and not more than 0.74%, preferably not less than 0.3% and not more than 0.5%. Therefore, the compound semiconductor solar battery can have improved performance as will be described later.

This embodiment is similar to the first and second embodiments except for the above description, and thus the description thereof will not be repeated.

<Fourth Embodiment>

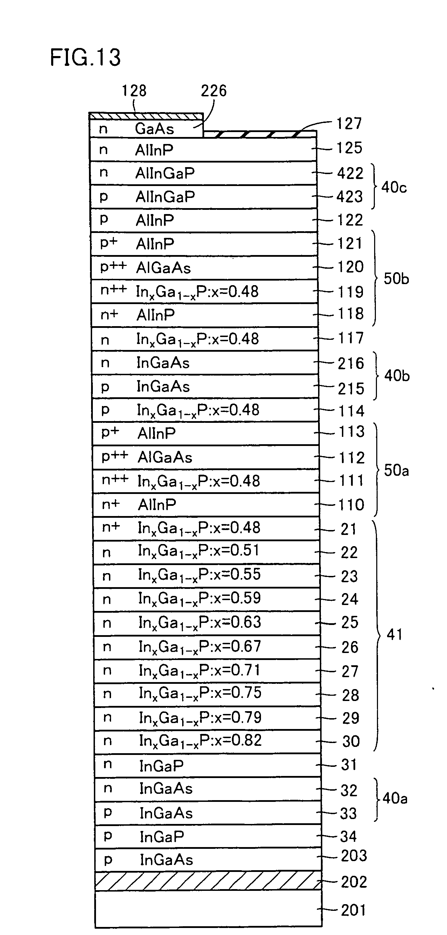

Fig. 13 is a schematic cross-sectional structure diagram of another example of the compound semiconductor solar battery according to the present invention. The compound semiconductor solar battery having the structure shown in Fig. 13 is formed by growing compound semiconductor layers on a p type Ge substrate, with an emitter layer 422 made of n type AlInGaP and a base layer 423 made of p type AlInGaP joined to each other constituting top cell 40c.

In the compound semiconductor solar battery having the structure shown in Fig. 13, on support substrate 201, metal layer 202, contact layer 203 made of p type InGaAs, BSF layer 34 made of p type InGaP, base layer 33 made of p type InGaAs, emitter layer 32 made of n type InGaAs, and window layer 31 made of n type InGaP are stacked in this order. Base layer 33 made of p type InGaAs and emitter layer 32 made of n type InGaAs joined to each other constitute bottom cell 40a.

On window layer 31 made of n type InGaP, n type $In_{0.82}Ga_{0.18}P$ layer 30, n type $In_{0.79}Ga_{0.21}P$ layer 29, n type $In_{0.75}Ga_{0.25}P$ layer 28, n type $In_{0.7}Ga_{0.29}P$ layer 27, n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 are stacked in this order. N type $In_{0.82}Ga_{0.18}P$ layer 30, n type $In_{0.79}Ga_{0.21}P$ layer 29, n type $In_{0.75}Ga_{0.25}P$ layer 28, n type $In_{0.7}Ga_{0.29}P$ layer 27. n type $In_{0.67}Ga_{0.33}P$ layer 26, n type $In_{0.63}Ga_{0.37}P$ layer 25, n type $In_{0.59}Ga_{0.41}P$ layer 24, n type $In_{0.55}Ga_{0.45}P$ layer 23, n type $In_{0.51}Ga_{0.49}P$ layer 22, and n+ type $In_{0.48}Ga_{0.52}P$ layer 21 constitute buffer layer 41.

On buffer layer 41, n+ type AlInP layer 110, n++ type $In_{0.48}Ga_{0.52}P$ layer 111, p++ type AlGaAs layer 112, and p+ type AlInP layer 113 are stacked in this order. N+ type AlInP layer 110, n++ type $In_{0.48}Ga_{0.52}P$ layer 111, p++ type AlGaAs layer 112, and p+ type AlInP layer 113 constitute tunnel junction layer 50a.

On tunnel junction layer 50a, BSF layer 114 made of p type $In_{0.48}Ga_{0.52}P$, base layer 215 made of p type InGaAs, emitter layer 216 made of n type InGaAs, and window layer 117 made of n type $In_{0.48}Ga_{0.52}P$ are stacked in this order. Base layer 215 made of p type InGaAs and emitter layer 216 made of n type InGaAs joined to each other constitute middle cell 40b.

On window layer 117 made of n type $In_{0.48}Ga_{0.52}P$, n+ type AlInP layer 118, n++ type $In_{0.48}Ga_{0.52}P$ layer 119, p++ type AlGaAs layer 120, and p+ type AlInP layer 121 are stacked in this order. N+ type AlInP layer 118, n++ type $In_{0.48}Ga_{0.52}P$ layer 119, p++ type AlGaAs layer 120, and p+ type AlInP layer 121 constitute tunnel junction layer 50b.

On p+ type AlInP layer 121, BSF layer 122 made of p type AlInP, base layer 423 made of p type AlInGaP (e.g. 3 $\mu$m thick), emitter layer 422 made of n type AlInGaP (e.g. 0.05 $\mu$m thick), and window layer 125 made of n type AlInP (e.g. 0.1 $\mu$m thick) are stacked in this order. Base layer 423 made of p type AlInGaP and emitter layer 422 made of n type AlInGaP joined to each other constitute top cell 40c.

On window layer 125 made of n type AlInP, contact layer 226 made of n type GaAs and antireflection film 127 are formed, and electrode layer 128 is formed on contact layer 226.

In the compound semiconductor solar battery shown in Fig. 13, a band gap increases in the order of the compound semiconductor layers constituting bottom cell 40a, the compound semiconductor layers constituting middle cell 40b, and the compound semiconductor layers constituting top cell 40c.

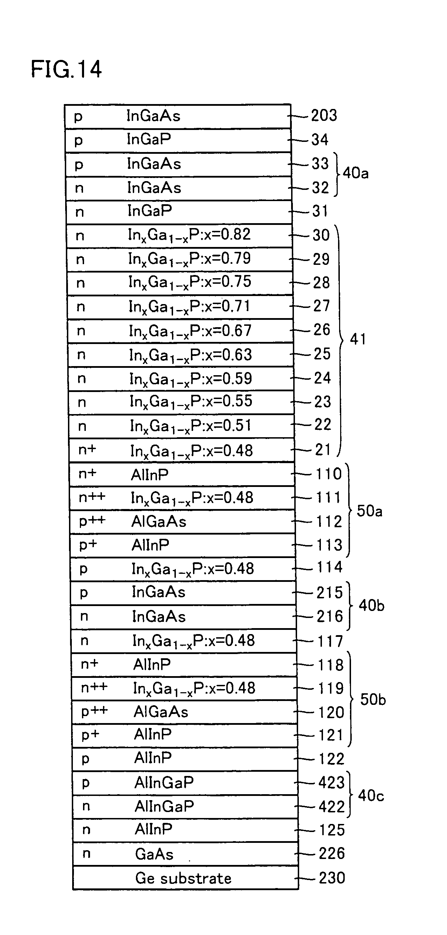

Referring to cross-sectional structure diagrams in Figs. 14 to 16, an example of a method for manufacturing the compound semiconductor solar battery having the structure shown in Fig. 13 will be described.

First, as shown in Fig. 14, a Ge substrate 230 having a diameter of 50 mm, for example, is placed in an MOCVD (Metal Organic Chemical Vapor Deposition) device, and on Ge substrate 230, contact layer 226 made of n type GaAs, window layer 125 made of n type AlInP, emitter layer 422 made of n type AlInGaP, base layer 423 made of p type AlInGaP, and BSF layer 122 made of p type AlInP are epitaxially grown in this order by MOCVD.

Next, on BSF layer 122 made of p type AlInP, p+ type AlInP layer 121, p++ type AlGaAs layer 120, n++ type $In_{0.48}Ga_{0.52}P$ layer 119, and n+ type AlInP layer 118 are epitaxially grown in this order by MOCVD.

Next, on n+ type AlInP layer 118, window layer 117 made of n type $In_{0.48}Ga_{0.52}P$, emitter layer 216 made of n type InGaAs, base layer 215 made of p type InGaAs, and BSF layer 114 made of p type $In_{0.48}Ga_{0.52}P$ are epitaxially grown in this order by MOCVD.

Next, on BSF layer 114 made of p type $In_{0.48}Ga_{0.52}P$, p+ type AlInP layer 113, p++ type AlGaAs layer 112, n++ type $In_{0.48}Ga_{0.52}P$ layer 111, and n+ type AlInP layer 110 are epitaxially grown in this order by MOCVD.

Next, on n+ type AlInP layer 110, n+ type $In_{0.48}Ga_{0.52}P$ layer 21, n type $In_{0.51}Ga_{0.49}P$ layer 22, n type $In_{0.55}Ga_{0.45}P$ layer 23, n type $In_{0.59}Ga_{0.41}P$ layer 24, n type $In_{0.63}Ga_{0.37}P$ layer 25, n type $In_{0.67}Ga_{0.33}P$ layer 26, n type $In_{0.71}Ga_{0.29}P$ layer 27, n type $In_{0.75}Ga_{0.25}P$ layer 28, n type $In_{0.79}Ca_{0.21}P$ layer 29, and n type $In_{0.82}Ga_{0.18}P$ layer 30 are epitaxially grown by MOCVD.

Next, on n type $In_{0.82}Ga_{0.18}P$ layer 30, n type InGaP layer 31, emitter layer 32 made of n type InGaAs, base layer 33 made of p type InGaAs, BSF layer 34 made of p type InGaP, and contact layer 203 made of p type InGaAs are epitaxially grown in this order by MOCVD.

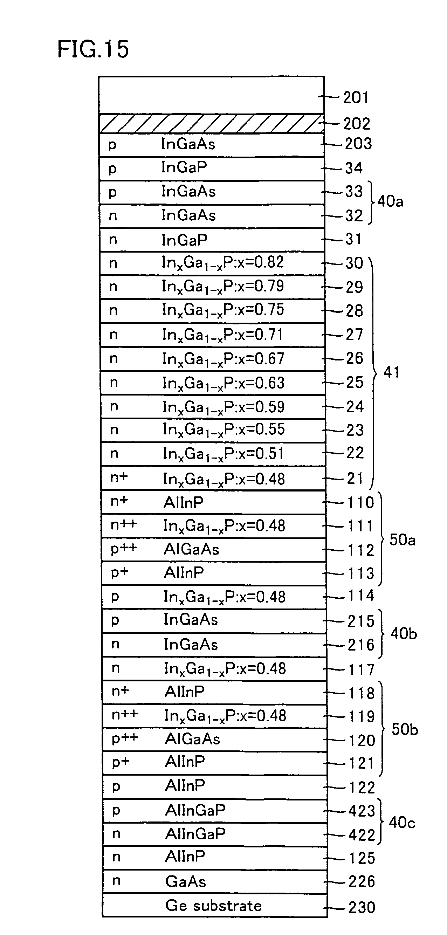

Then, as shown in Fig. 15, support substrate 201 is attached to a surface of contact layer 203 made of p type InGaAs via metal layer 202 formed of a stacked body including Au (e.g. 0.1 $\mu$m thick)/Ag (e.g. $\mu$m thick), for example.

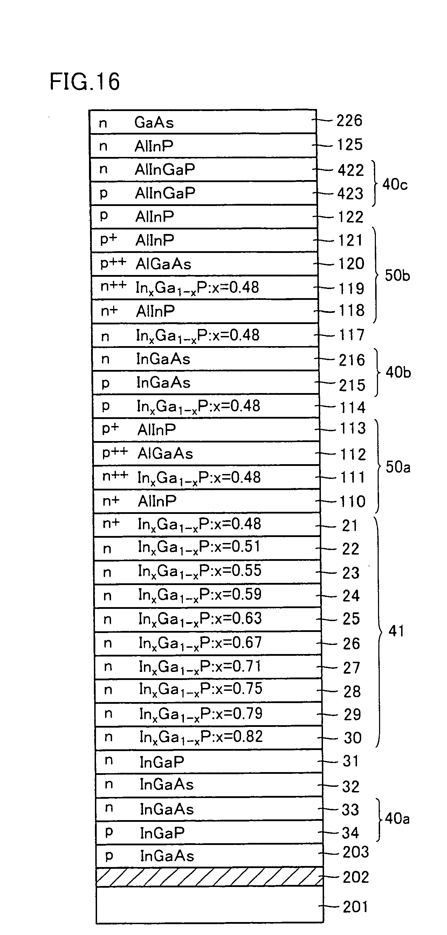

Next, as shown in Fig. 16, Ge substrate 230 is etched with a hydrofluoric aqueous solution.

Next, a resist pattern is formed by photolithography on contact layer 226 made of n type GaAs, and then contact layer 226 is partially removed by etching with an alkaline aqueous solution. Then, a resist pattern is formed by photolithography again on a surface of remaining contact layer 226, and electrode layer 128 formed of a stacked body including AuGe (12%) (e.g. 0.1 $\mu$m thick)/Ni (e.g. 0.02 $\mu$m thick)/Au (e.g. 0.1 $\mu$m thick)/Ag (e.g. 5 $\mu$m thick), for example, is formed using a resistance heating evaporation device and an EB (Electron Beam) evaporation device.

Next, a mesa etching pattern is formed, and then mesa etching is performed with an alkaline aqueous solution and an acid solution. Then, a stacked body including a $TiO_2$ film (e.g. 55 nm thick) and an $Al_2O_3$ film (e.g. 85 nm thick), for example, is formed by EB evaporation, to form antireflection film 127. As a result, the compound semiconductor solar battery having the structure shown in Fig. 13 with a light-receiving surface positioned opposite to a growth direction of the compound semiconductor can be obtained.

In the compound semiconductor solar battery having the structure shown in Fig. 13, buffer layer 41 is provided between bottom cell 40a and middle cell 40b. Bottom cell 40a and buffer layer 41 are arranged adjacent to and in contact with each other, and the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is not less than 0.15% and not more than 0.74%, preferably not less than 0.3% and not more than 0.5%.

Thus, between bottom cell 40a and buffer layer 41 adjacent to each other in the compound semiconductor solar battery having the structure shown in Fig. 13, the ratio of the difference in lattice constant between base layer 33 made of p type InGaAs among the compound semiconductor layers constituting bottom cell 40a and n type $In_{0.82}Ga_{0.18}P$ layer 30 arranged in the position closest to bottom cell 40a among the compound semiconductor layers constituting buffer layer 41 is again not less than 0.15% and not more than 0.74%, preferably not less than 0.3% and not more than 0.5%. Therefore, the compound semiconductor solar battery can have improved performance as will be described later.

This embodiment is similar to the first to third embodiments except for the above description, and thus the description thereof will not be repeated.

EXAMPLES

<Making of Compound Semiconductor Solar Batteries>

First, as shown in Fig. 2, GaAs substrate 130 having a diameter of 50 mm was placed in an MOCVD device, and on GaAs substrate 130, etching stop layer 131 made of n type $In_{0.48}Ga_{0.52}P$, contact layer 126 made of n type GaAs having a thickness of 0.4 $\mu$m, window layer 125 made of n type AlInP having a thickness of 0.05 $\mu$m, emitter layer 124 made of n type $In_{0.48}Ga_{0.52}P$ having a thickness of 0.05 $\mu$m, base layer 123 made of p type $In_{0.48}Ga_{0.52}P$ having a thickness of 0.65 $\mu$m, and BSF layer 122 made of p type AlInP having a thickness of 0.4 $\mu$m were epitaxially grown in this order by MOCVD.

Next, on BSF layer 122 made of p type AlInP having a thickness of 0.05 $\mu$m, p+ type AlInP layer 121 having a thickness of 0.05 $\mu$m, p++ type AlGaAs layer 120 having a thickness of 0.02 $\mu$m, n++ type $In_{0.48}Ga_{0.52}P$ layer 119 having a thickness of 0.02 $\mu$m, and n+ type AlInP layer 118 having a thickness of 0.05 $\mu$m were epitaxially grown in this order by MOCVD.

Next, on n+ type AlInP layer 118, window layer 117 made of n type $In_{0.48}Ga_{0.52}P$ having a thickness of 0.1 $\mu$m, emitter layer 116 made of n type GaAs having a thickness of 0.1 $\mu$m, base layer 115 made of p type GaAs having a thickness of 3 $\mu$m, and BSF layer 114 made of p type $In_{0.48}Ga_{0.52}P$ having a thickness of 0.1 $\mu$m were epitaxially grown in this order by MOCVD.

Next, on BSF layer 114 made of p type $In_{0.48}Ga_{0.52}P$. p+ type AlInP layer 113 having a thickness of 0.05 $\mu$m, p++ type AlGaAs layer 112 having a thickness of 0.02 $\mu$m, n++ type $In_{0.48}Ga_{0.52}P$ layer 111 having a thickness of 0.02 $\mu$m, and n+ type AlInP layer 110 having a thickness of 0.05 $\mu$m were epitaxially grown in this order by MOCVD.

Next, on n+ type AlInP layer 110, n+ type $In_{0.48}Ga_{0.52}P$ layer 21 having a thickness of 0.25 $\mu$m, n type $In_{0.51}Ga_{0.49}P$ layer 22 having a thickness of 0.25 $\mu$m, n type $In_{0.55}Ga_{0.45}P$ layer 23 having a thickness of 0.25 $\mu$m, n type $In_{0.59}Ga_{0.41}P$ layer 24 having a thickness of 0.25 $\mu$m, n type $In_{0.63}Ga_{0.37}P$ layer 25, n type $In_{0.67}Ga_{0.33}P$ layer 26 having a thickness of 0.25 $\mu$m, n type $In_{0.71}Ga_{0.29}P$ layer 27 having a thickness of 0.25 $\mu$m, n type $In_{0.75}Ga_{0.25}P$ layer 28 having a thickness of 0.25 $\mu$m, n type $In_{0.79}Ga_{0.21}P$ layer 29 having a thickness of 0.25 $\mu$m, and n type $In_{0.82}Ga_{0.18}P$ layer 30 having a thickness of 1 $\mu$m were epitaxially grown by MOCVD.

Next, on n type $In_{0.82}Ga_{0.18}P$ layer 30, n type InGaP layer 31 having a thickness of 0.1 $\mu$m, emitter layer 32 made of n type InGaAs having a thickness of 0.1 $\mu$m, base layer 33 made of p type InGaAs having a thickness of 3 $\mu$m, BSF layer 34 made of p type InGaP having a thickness of 0.1 $\mu$m, and contact layer 35 made of p type InGaAs having a thickness of 0.4 $\mu$m were epitaxially grown in this order by MOCVD.

Then, as shown in Fig. 3, support substrate 101 was attached to a surface of contact layer 35 made of p type InGaAs via metal layer 102 formed of a stacked body including Au (0.1 $\mu$m thick)/Ag (3 $\mu$m thick), for example.

Next, as shown in Fig. 4, GaAs substrate 130 was etched with an alkaline aqueous solution, and then etching stop layer 131 made of n type $In_{0.48}Ga_{0.52}P$ was etched with an acid solution.

Next, a resist pattern was formed by photolithography on contact layer 126 made of n type GaAs, and then contact layer 126 was partially removed by etching with an alkaline aqueous solution. Then, a resist pattern was formed by photolithography again on a surface of remaining contact layer 126, and electrode layer 128 formed of a stacked body including AuGe (12%) (0.1 $\mu$m thick)/Ni (0.02 $\mu$m thick)/Au (0.1 $\mu$m thick)/Ag (5 $\mu$m thick), for example, was formed using a resistance heating evaporation device and an EB (Electron Beam) evaporation device.

Next, a mesa etching pattern was formed, and then mesa etching was performed with an alkaline aqueous solution and an acid solution. Then, a stacked body including a $TiO_2$ film (55 nm thick) and an $Al_2O_3$ film (85 nm thick) was formed by EB evaporation, to form antireflection film 127. As a result, the compound semiconductor solar battery having the structure shown in Fig. 1 with a light-receiving surface positioned opposite to a growth direction of the compound semiconductor was obtained.

Seven types of compound semiconductor solar batteries No. 1 to No. 7 were made. The compound semiconductor solar batteries No. 1 to No. 4 and No. 6 to No. 7 were made with varying compositions of base layer 33 of bottom cell 40a with a constant composition of n type $In_{0.82}Ga_{0.18}P$ layer 30 which is a top layer during manufacture of buffer layer 41, and with varying compositions of window layer 31 and emitter layer 32 such that each of them had a lattice constant similar to that of base layer 33.

The compound semiconductor solar battery No. 5 was made with a different composition of each p type InGaP layer constituting buffer layer 41 and a different composition of base layer 33 of bottom cell 40a from those of the compound semiconductor solar batteries No. 6 to No. 7.

<Making of Samples>

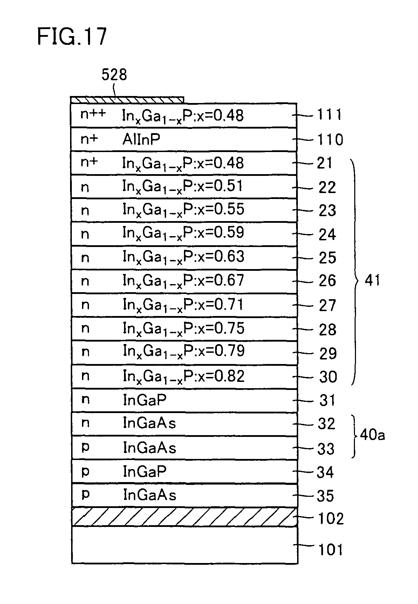

Next, in order to evaluate bottom cell 40a, p++ type AlGaAs layer 112, p+ type AlInP layer 113, BSF layer 114, middle cell 40b, window layer 117, tunnel junction layer 50b, BSF layer 122, top cell 40c, window layer 125, contact layer 126, antireflection film 127, and electrode layer 128 were removed from each of the compound semiconductor solar batteries No. 1 to No. 7, and then an electrode 528 was formed on a surface of exposed n++ type $In_{0.48}Ga_{0.52}P$ layer 111. As a result, samples No. 1 to No. 7 having a structure shown in a schematic cross-sectional view of Fig. 17 were made from the compound semiconductor solar batteries No. 1 to No. 7, respectively.

In the making of the samples No. 1 to No. 7 from the above compound semiconductor solar batteries No. 1 to No. 7, it is needless to say that the number of a compound semiconductor solar battery corresponds to the number of a sample.

<Evaluation>

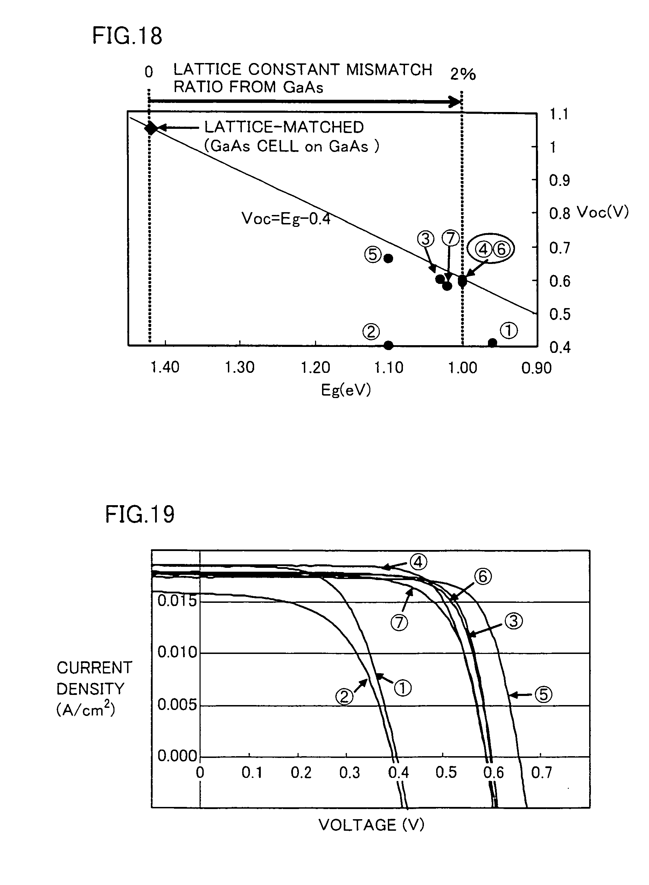

A surface state of contact layer 35 made of p type InGaAs, which was exposed as a top surface during the making of each of the above compound semiconductor solar batteries No. 1 to No. 7, was visually observed. Further, current-voltage characteristics of each of the above samples No. 1 to No. 7 were measured, and open-circuit voltages were measured from the current-voltage characteristics. The results are shown in Table 1, Figs. 18 and 19.

In Table 1, evaluations A and B of the surface state indicate the following surface states, respectively.

A ... Good surface state of contact layer 35 made of p type InGaAs

B ... Poor surface state of contact layer 35 made of p type InGaAs

In Figs. 18 and 19, circled figures indicate the numbers of the samples No. 1 to No. 7, respectively.

Fig. 18 illustrates relation between Eg (band gap energy; in eV) of base layer 33 of bottom cell 40a and Voc (open-circuit voltage; in V) of bottom cell 40a in each of the above samples No. 1 to No. 7, with a horizontal axis representing Eg and a vertical axis representing Voc.

A line Voc = Eg - 0.4 having a slope in Fig. 18 indicates relation between Eg and Voc assuming that base layer 33 of bottom cell 40a has best crystallinity, which shows that the closer the position of a black circle in Fig. 18 is to this line, the better the characteristics of bottom cell 40a.

A lattice constant mismatch ratio from GaAs indicated in Fig. 18 represents the degree of lattice constant mismatch between GaAs and base layer 33 of bottom cell 40a. Fig. 19 illustrates relation between a voltage (in V) and a current density (in A/cm$^2$) (current-voltage characteristics) in each of the above samples No. 1 to No. 7, with a horizontal axis representing the voltage and a vertical axis representing the current density.

[Table 1]

| No. | Structure | | | | Result | |
|---|---|---|---|---|---|---|
| | Bottom Cell Base Layer | | Top Layer During Manufacture of Buffer Layer | Ratio of Difference in Lattice Constant (%) | Surface State | Voc |
| | Lattice Constant a2 (nm) | Eg (eV) | Lattice Constant al (nm) | $(100 \times (a1 - a2))/(a1)$ | | |
| 1 | 57.95 | 0.96 | 58.00 | 0.09 | A | 0.41 |
| 2 | 57.51 | 1.1 | 58.01 | 0.86 | B | 0.4 |
| 3 | 57.72 | 1.03 | 58.01 | 0.49 | A | 0.6 |
| 4 | 57.83 | 1 | 58.00 | 0.3 | A | 0.59 |
| 5 | 57.51 | 1.1 | 57.80 | 0.5 | A | 0.66 |
| 6 | 57.83 | 1 | 57.92 | 0.15 | A | 0.6 |
| 7 | 57.76 | 1.02 | 58.19 | 0.74 | A | 0.58 |

<Results>

As shown in Table 1, Figs. 18 and 19, the compound semiconductor solar batteries No. 3 to No. 7 were superior to the compound semiconductor solar battery No. 2 in surface state of contact layer 35 made of p type InGaAs.

Further, as shown in Table 1, Figs. 18 and 19, it was confirmed that the samples No. 3 to No. 7 were superior to the samples No. 1 to No. 2 in characteristics such as the open-circuit voltage of bottom cell 40a.

It is considered that this is because in each of the compound semiconductor solar batteries No. 3 to No. 7 and the samples No. 3 to No. 7, the ratio of the difference in lattice constant $(100 \times (al - a2)) / (al)$ between lattice constant a1 of n type $In_{0.82}Ga_{0.18}P$ layer 30 of buffer layer 41 and lattice constant a2 of base layer 33 of bottom cell 40a is within a range of not less than 0.15% and not more than 0.74%.

In addition, the samples No. 3 to No. 5 having the ratio of the difference in lattice constant of not less than 0.3% and not more than 0.5% had the tendency to have even better characteristics.

In this example, lattice constant a1 of n type $In_{0.82}Ga_{0.18}P$ layer 30 of buffer layer 41 and lattice constant a2 of base layer 33 of bottom cell 40a were obtained by placing the compound semiconductor solar batteries No. 1 to No. 7 before support substrate 101 was attached thereto via metal layer 102 in an X-ray diffraction device, and applying X-rays from the side (side of contact layer 35 made of p type InGaAs) opposite to the light-receiving surface by an X-ray diffraction method.

While the characteristics of bottom cell 40a are evaluated in this embodiment, when a multi-junction type compound semiconductor solar battery such as a two-junction type or a three-junction type is made by providing compound semiconductor photoelectric conversion cells such as middle cell 40b and top cell 40c on bottom cell 40a with buffer layer 41 interposed therebetween, it is considered that the performance of such multi-junction type compound semiconductor solar battery is improved again due to the excellent characteristics of bottom cell 40a.

While the above ratio of the difference in lattice constant is changed mainly by varying the composition of base layer 33 of bottom cell 40a in this embodiment, the above ratio of the difference in lattice constant can be changed by varying the composition of n type $In_{0.82}Ga_{0.18}P$ layer 30 of buffer layer 41, or the above ratio of the difference in lattice constant can be changed by varying the composition of base layer 33 of bottom cell 40a and the composition of n type $In_{0.82}Ga_{0.18}P$ layer 30 of buffer layer 41.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

INDUSTRIAL APPLICABILITY

The present invention may be applicable to a compound semiconductor solar battery, and a method for manufacturing the compound semiconductor solar battery.

REFERENCE SIGNS LIST

21 n+ type $In_{0.48}Ga_{0.52}P$ layer; 22 n type $In_{0.51}Ga_{0.49}P$ layer; 23 n type $In_{0.55}Ga_{0.45}P$ layer; 24 n type $In_{0.59}Ga_{0.41}P$ layer; 25 n type $In_{0.63}Ga_{0.37}P$ layer; 26 n type $In_{0.67}Ga_{0.33}P$ layer; 27 n type $In_{0.71}Ga_{0.29}P$ layer; 28 n type $In_{0.75}Ga_{0.25}P$ layer; 29 n type $In_{0.79}Ga_{0.21}P$ layer; 30 n type $In_{0.82}Ga_{0.18}P$ layer; 31 window layer; 32 emitter layer; 33 base layer; 34 BSF layer; 35 contact layer; 40a bottom cell; 40b middle cell; 40c top cell; 41 buffer layer; 50a, 50b tunnel junction layer; 101 support substrate; 102 metal layer; 110 n+ type AlInP layer; 111 n++ type $In_{0.48}Ga_{0.52}P$ layer; 112 p++ type AlGaAs layer; 113 p+ type AlInP layer; 114 BSF layer; 115 base layer; 116 emitter layer; 117 window layer; 118 n+ type AlInP layer; 119 n++ type $In_{0.48}Ga_{0.52}P$ layer; 120 p++ type AlGaAs layer; 121 p+ type AlInP layer; 122 BSF layer; 123 base layer; 124 emitter layer; 125 window layer; 126 contact layer; 127 antireflection film; 128 electrode layer; 130 GaAs substrate; 131 etching stop layer; 201 support substrate; 202 metal layer; 203 contact layer; 223 base layer; 224 emitter layer; 226 contact layer; 230 Ge substrate; 323 base layer; 324 emitter layer; 422 emitter layer; 423 base layer; 528 electrode.

**Claims**

1. A compound semiconductor solar battery comprising:

   a first compound semiconductor photoelectric conversion cell (40a);
   a second compound semiconductor photoelectric conversion cell (40b) provided on said first compound semiconductor photoelectric conversion cell (40a); and
   a compound semiconductor buffer layer (41) provided between said first compound semiconductor photoelectric conversion cell (40a) and said second compound semiconductor photoelectric conversion cell (40b),
   said first compound semiconductor photoelectric conversion cell (40a) and said compound semiconductor buffer layer (41) being provided adjacent to each other, and
   a ratio of a difference in lattice constant between said first compound semiconductor photoelectric conversion cell (40a) and a compound semiconductor layer (30) provided in a position closest to said first compound semiconductor photoelectric conversion cell (40a) among compound semiconductor layers constituting said compound semiconductor buffer layer (41) being not less than 0.15% and not more than 0.74%.

2. A compound semiconductor solar battery comprising:

   a first compound semiconductor photoelectric conversion cell (40a);
   a second compound semiconductor photoelectric conversion cell (40b); and
   a compound semiconductor buffer layer (41) provided between said first compound semiconductor photoelectric conversion cell (40a) and said second compound semiconductor photoelectric conversion cell (40b),
   said compound semiconductor buffer layer (41) having a lattice constant increasing from said second compound semiconductor photoelectric conversion cell (40b) toward said first compound semiconductor photoelectric conversion cell (40a),
   said first compound semiconductor photoelectric conversion cell (40a) having a lattice constant smaller than a lattice constant of a compound semiconductor layer (30) provided in a position closest to said first compound semiconductor photoelectric conversion cell (40a) in said compound semiconductor buffer layer (41), and a ratio of a difference in lattice constant between said first compound semiconductor photoelectric conversion cell (40a) and the compound semiconductor layer (30) provided in the position closest to said first compound semiconductor photoelectric conversion cell (40a) in said compound semiconductor buffer layer (41) being not less than 0.15%.

3. The compound semiconductor solar battery according to claim 2, wherein the ratio of the difference in lattice constant between said first compound semiconductor photoelectric conversion cell (40a) and the compound semiconductor layer (30) provided in the position closest to said first compound semiconductor photoelectric conversion cell (40a) in said compound semiconductor buffer layer (41) is not more than 0.74%.

4. The compound semiconductor solar battery according to claim 1, wherein a ratio of a difference in lattice constant between a base layer (33) among compound semiconductor layers constituting said first compound semiconductor photoelectric conversion cell (40a) and the compound semiconductor layer (30) provided in the position closest to said first compound semiconductor photoelectric conversion cell (40a) among the compound semiconductor layers constituting said compound semiconductor buffer layer (41) is not less than 0.15% and not more than 0.74%.

5. The compound semiconductor solar battery according to claim 1, wherein a compound semiconductor constituting said first compound semiconductor photoelectric conversion cell (40a) has band gap energy of not less than 0.9 eV and not more than 1.1 eV.

6. The compound semiconductor solar battery according to claim 1, wherein a compound semiconductor constituting said first compound semiconductor photoelectric conversion cell (40a) includes InGaAs.

7. The compound semiconductor solar battery according to claim 1, wherein a compound semiconductor constituting said second compound semiconductor photoelectric conversion cell (40b) includes one of GaAs and InGaAs.

8. The compound semiconductor solar battery according to claim 1, further comprising a third compound semiconductor photoelectric conversion cell (40c) provided on said second compound semiconductor photoelectric conversion cell (40b).

9. The compound semiconductor solar battery according to claim 8, wherein a compound semiconductor constituting said third compound semiconductor photoelectric conversion cell (40c) includes one of InGaP and AlInGap.

10. A method for manufacturing the compound semiconductor solar battery according to claim 1, comprising the steps of:

forming said second compound semiconductor photoelectric conversion cell (40b) on a semiconductor substrate (130, 230);
forming said compound semiconductor buffer layer (41) on said second compound semiconductor photoelectric conversion cell (40b); and
forming said first compound semiconductor photoelectric conversion cell (40a) on said compound semiconductor buffer layer (41).

11. The method for manufacturing the compound semiconductor solar battery according to claim 10, further comprising the step of removing said semiconductor substrate (130, 230).

12. A method for manufacturing the compound semiconductor solar battery according to claim 8, comprising the steps of:

forming said third compound semiconductor photoelectric conversion cell (40c) on a semiconductor substrate (130, 230);
forming said second compound semiconductor photoelectric conversion cell (40b) on said third compound semiconductor photoelectric conversion cell (40c);
forming said compound semiconductor buffer layer (41) on said second compound semiconductor photoelectric conversion cell (40b); and
forming said first compound semiconductor photoelectric conversion cell (40a) on said compound semiconductor buffer layer (41).

13. The method for manufacturing the compound semiconductor solar battery according to claim 12, further comprising the step of removing said semiconductor substrate (130, 230).

14. A method for manufacturing the compound semiconductor solar battery according to claim 8, comprising the steps of:

forming said third compound semiconductor photoelectric conversion cell (40c) on a semiconductor substrate (130, 230) by epitaxial growth;
forming a first tunnel junction layer (50b) on said third compound semiconductor photoelectric conversion cell (40c) by epitaxial growth;
forming said second compound semiconductor photoelectric conversion cell (40b) on said first tunnel junction layer (50b) by epitaxial growth;
forming a second tunnel junction layer (50a) on said second compound semiconductor photoelectric conversion cell (40b) by epitaxial growth;
forming said compound semiconductor buffer layer (41) on said second tunnel junction layer (50a) by epitaxial growth; and
forming said first compound semiconductor photoelectric conversion cell (40a) on said compound semiconductor buffer layer (41) by epitaxial growth.

15. The method for manufacturing the compound semiconductor solar battery according to claim 14, further comprising the step of removing said semiconductor substrate (130, 230).

# FIG.1

| | | |
|---|---|---|
| | 128 | 126 |

| | | |
|---|---|---|
| n | GaAs | — 127 |
| n | AlInP | — 125 |
| n | $In_xGa_{1-x}P$:x=0.48 | — 124 } 40c |
| p | $In_xGa_{1-x}P$:x=0.48 | — 123 |
| p | AlInP | — 122 |
| p+ | AlInP | — 121 |
| p++ | AlGaAs | — 120 } 50b |
| n++ | $In_xGa_{1-x}P$:x=0.48 | — 119 |
| n+ | AlInP | — 118 |
| n | $In_xGa_{1-x}P$:x=0.48 | — 117 |
| n | GaAs | — 116 } 40b |
| p | GaAs | — 115 |
| p | $In_xGa_{1-x}P$:x=0.48 | — 114 |
| p+ | AlInP | — 113 |
| p++ | AlGaAs | — 112 } 50a |
| n++ | $In_xGa_{1-x}P$:x=0.48 | — 111 |
| n+ | AlInP | — 110 |
| n+ | $In_xGa_{1-x}P$:x=0.48 | — 21 |
| n | $In_xGa_{1-x}P$:x=0.51 | — 22 |
| n | $In_xGa_{1-x}P$:x=0.55 | — 23 |
| n | $In_xGa_{1-x}P$:x=0.59 | — 24 |
| n | $In_xGa_{1-x}P$:x=0.63 | — 25 |
| n | $In_xGa_{1-x}P$:x=0.67 | — 26 } 41 |
| n | $In_xGa_{1-x}P$:x=0.71 | — 27 |
| n | $In_xGa_{1-x}P$:x=0.75 | — 28 |
| n | $In_xGa_{1-x}P$:x=0.79 | — 29 |
| n | $In_xGa_{1-x}P$:x=0.82 | — 30 |
| n | InGaP | — 31 |
| n | InGaAs | — 32 } 40a |
| p | InGaAs | — 33 |
| p | InGaP | — 34 |
| p | InGaAs | — 35 |
| | | — 102 |
| | | — 101 |

## FIG.2

| p | InGaAs | — 35 | |
|---|---|---|---|
| p | InGaP | — 34 | |
| p | InGaAs | — 33 | 40a |
| n | InGaAs | — 32 | |
| n | InGaP | — 31 | |
| n | $In_xGa_{1-x}P$:x=0.82 | — 30 | |
| n | $In_xGa_{1-x}P$:x=0.79 | — 29 | |
| n | $In_xGa_{1-x}P$:x=0.75 | — 28 | |
| n | $In_xGa_{1-x}P$:x=0.71 | — 27 | |
| n | $In_xGa_{1-x}P$:x=0.67 | — 26 | |
| n | $In_xGa_{1-x}P$:x=0.63 | — 25 | 41 |
| n | $In_xGa_{1-x}P$:x=0.59 | — 24 | |
| n | $In_xGa_{1-x}P$:x=0.55 | — 23 | |
| n | $In_xGa_{1-x}P$:x=0.51 | — 22 | |
| n+ | $In_xGa_{1-x}P$:x=0.48 | — 21 | |
| n+ | AlInP | — 110 | |
| n++ | $In_xGa_{1-x}P$:x=0.48 | — 111 | 50a |
| p++ | AlGaAs | — 112 | |
| p+ | AlInP | — 113 | |
| p | $In_xGa_{1-x}P$:x=0.48 | — 114 | |
| p | GaAs | — 115 | 40b |
| n | GaAs | — 116 | |
| n | $In_xGa_{1-x}P$:x=0.48 | — 117 | |
| n+ | AlInP | — 118 | |
| n++ | $In_xGa_{1-x}P$:x=0.48 | — 119 | 50b |
| p++ | AlGaAs | — 120 | |
| p+ | AlInP | — 121 | |
| p | AlInP | — 122 | |
| p | $In_xGa_{1-x}P$:x=0.48 | — 123 | 40c |
| n | $In_xGa_{1-x}P$:x=0.48 | — 124 | |
| n | AlInP | — 125 | |
| n | GaAs | — 126 | |
| n | $In_xGa_{1-x}P$:x=0.48 | — 131 | |
| | GaAs substrate | — 130 | |

## FIG.3

| | | |
|---|---|---|
| | | 101 |
| | /////////// | 102 |
| p | InGaAs | 35 |
| p | InGaP | 34 |
| p | InGaAs | 33 |
| n | InGaAs | 32 |
| n | InGaP | 31 |
| n | $In_xGa_{1-x}P : x = 0.82$ | 30 |
| n | $In_xGa_{1-x}P : x = 0.79$ | 29 |
| n | $In_xGa_{1-x}P : x = 0.75$ | 28 |
| n | $In_xGa_{1-x}P : x = 0.71$ | 27 |
| n | $In_xGa_{1-x}P : x = 0.67$ | 26 |
| n | $In_xGa_{1-x}P : x = 0.63$ | 25 |
| n | $In_xGa_{1-x}P : x = 0.59$ | 24 |
| n | $In_xGa_{1-x}P : x = 0.55$ | 23 |
| n | $In_xGa_{1-x}P : x = 0.51$ | 22 |
| n+ | $In_xGa_{1-x}P : x = 0.48$ | 21 |
| n+ | AlInP | 110 |
| n++ | $In_xGa_{1-x}P : x = 0.48$ | 111 |
| p++ | AlGaAs | 112 |
| p+ | AlInP | 113 |
| p | $In_xGa_{1-x}P : x = 0.48$ | 114 |
| p | GaAs | 115 |
| n | GaAs | 116 |
| n | $In_xGa_{1-x}P : x = 0.48$ | 117 |
| n+ | AlInP | 118 |
| n++ | $In_xGa_{1-x}P : x = 0.48$ | 119 |
| p++ | AlGaAs | 120 |
| p+ | AlInP | 121 |
| p | AlInP | 122 |
| p | $In_xGa_{1-x}P : x = 0.48$ | 123 |
| n | $In_xGa_{1-x}P : x = 0.48$ | 124 |
| n | AlInP | 125 |
| n | GaAs | 126 |
| n | $In_xGa_{1-x}P : x = 0.48$ | 131 |
| | GaAs substrate | 130 |

Brackets: 33–32 = 40a; 30–21 = 41; 110–113 = 50a; 115–116 = 40b; 118–121 = 50b; 123–124 = 40c.

FIG.4

| n | GaAs | 126 | |
|---|------|-----|---|
| n | AlInP | 125 | |
| n | $In_xGa_{1-x}P$:x=0.48 | 124 | 40c |
| p | $In_xGa_{1-x}P$:x=0.48 | 123 | |
| p | AlInP | 122 | |
| p+ | AlInP | 121 | |
| p++ | AlGaAs | 120 | 50b |
| n++ | $In_xGa_{1-x}P$:x=0.48 | 119 | |
| n+ | AlInP | 118 | |
| n | $In_xGa_{1-x}P$:x=0.48 | 117 | |
| n | GaAs | 116 | 40b |
| p | GaAs | 115 | |
| p | $In_xGa_{1-x}P$:x=0.48 | 114 | |
| p+ | AlInP | 113 | |
| p++ | AlGaAs | 112 | 50a |
| n++ | $In_xGa_{1-x}P$:x=0.48 | 111 | |
| n+ | AlInP | 110 | |
| n+ | $In_xGa_{1-x}P$:x=0.48 | 21 | |
| n | $In_xGa_{1-x}P$:x=0.51 | 22 | |
| n | $In_xGa_{1-x}P$:x=0.55 | 23 | |
| n | $In_xGa_{1-x}P$:x=0.59 | 24 | |
| n | $In_xGa_{1-x}P$:x=0.63 | 25 | |
| n | $In_xGa_{1-x}P$:x=0.67 | 26 | 41 |
| n | $In_xGa_{1-x}P$:x=0.71 | 27 | |
| n | $In_xGa_{1-x}P$:x=0.75 | 28 | |
| n | $In_xGa_{1-x}P$:x=0.79 | 29 | |
| n | $In_xGa_{1-x}P$:x=0.82 | 30 | |
| n | InGaP | 31 | |
| n | InGaAs | 32 | 40a |
| p | InGaAs | 33 | |
| p | InGaP | 34 | |
| p | InGaAs | 35 | |
| | | 102 | |
| | | 101 | |

# FIG.5

| | | | |
|---|---|---|---|
| n | GaAs | 127 | |
| n | AlInP | 125 | |
| n | AlInGaP | 324 | 40c |
| p | AlInGaP | 323 | |
| p | AlInP | 122 | |
| p+ | AlInP | 121 | |
| p++ | AlGaAs | 120 | 50b |
| n++ | $In_xGa_{1-x}P$:x=0.48 | 119 | |
| n+ | AlInP | 118 | |
| n | $In_xGa_{1-x}P$:x=0.48 | 117 | |
| n | GaAs | 116 | 40b |
| p | GaAs | 115 | |
| p | $In_xGa_{1-x}P$:x=0.48 | 114 | |
| p+ | AlInP | 113 | |
| p++ | AlGaAs | 112 | 50a |
| n++ | $In_xGa_{1-x}P$:x=0.48 | 111 | |
| n+ | AlInP | 110 | |
| n+ | $In_xGa_{1-x}P$:x=0.48 | 21 | |
| n | $In_xGa_{1-x}P$:x=0.51 | 22 | |
| n | $In_xGa_{1-x}P$:x=0.55 | 23 | |
| n | $In_xGa_{1-x}P$:x=0.59 | 24 | |
| n | $In_xGa_{1-x}P$:x=0.63 | 25 | |
| n | $In_xGa_{1-x}P$:x=0.67 | 26 | 41 |
| n | $In_xGa_{1-x}P$:x=0.71 | 27 | |
| n | $In_xGa_{1-x}P$:x=0.75 | 28 | |
| n | $In_xGa_{1-x}P$:x=0.79 | 29 | |
| n | $In_xGa_{1-x}P$:x=0.82 | 30 | |
| n | InGaP | 31 | |
| n | InGaAs | 32 | 40a |
| p | InGaAs | 33 | |
| p | InGaP | 34 | |
| p | InGaAs | 35 | |
| | | 102 | |
| | | 101 | |

128   126

## FIG.6

| p | InGaAs | — 35 | |
|---|---|---|---|
| p | InGaP | — 34 | |
| p | InGaAs | — 33 | } 40a |
| n | InGaAs | — 32 | |
| n | InGaP | — 31 | |
| n | $In_xGa_{1-x}P:x=0.82$ | — 30 | |
| n | $In_xGa_{1-x}P:x=0.79$ | — 29 | |
| n | $In_xGa_{1-x}P:x=0.75$ | — 28 | |
| n | $In_xGa_{1-x}P:x=0.71$ | — 27 | |
| n | $In_xGa_{1-x}P:x=0.67$ | — 26 | } 41 |
| n | $In_xGa_{1-x}P:x=0.63$ | — 25 | |
| n | $In_xGa_{1-x}P:x=0.59$ | — 24 | |
| n | $In_xGa_{1-x}P:x=0.55$ | — 23 | |
| n | $In_xGa_{1-x}P:x=0.51$ | — 22 | |
| n+ | $In_xGa_{1-x}P:x=0.48$ | — 21 | |
| n+ | AlInP | — 110 | |
| n++ | $In_xGa_{1-x}P:x=0.48$ | — 111 | } 50a |
| p++ | AlGaAs | — 112 | |
| p+ | AlInP | — 113 | |
| p | $In_xGa_{1-x}P:x=0.48$ | — 114 | |
| p | GaAs | — 115 | } 40b |
| n | GaAs | — 116 | |
| n | $In_xGa_{1-x}P:x=0.48$ | — 117 | |
| n+ | AlInP | — 118 | |
| n++ | $In_xGa_{1-x}P:x=0.48$ | — 119 | } 50b |
| p++ | AlGaAs | — 120 | |
| p+ | AlInP | — 121 | |
| p | AlInP | — 122 | |
| p | AlInGaP | — 323 | } 40c |
| n | AlInGaP | — 324 | |
| n | AlInP | — 125 | |
| n | GaAs | — 126 | |
| n | $In_xGa_{1-x}P:x=0.48$ | — 131 | |
| | GaAs substrate | — 130 | |

## FIG.7

| | | |
|---|---|---|
| | | 101 |
| ///////// (hatched) | | 102 |
| p | InGaAs | 35 |
| p | InGaP | 34 |
| p | InGaAs | 33 ⎫ 40a |
| n | InGaAs | 32 ⎭ |
| n | InGaP | 31 |
| n | $In_xGa_{1-x}P$:x=0.82 | 30 ⎫ |
| n | $In_xGa_{1-x}P$:x=0.79 | 29 |
| n | $In_xGa_{1-x}P$:x=0.75 | 28 |
| n | $In_xGa_{1-x}P$:x=0.71 | 27 |
| n | $In_xGa_{1-x}P$:x=0.67 | 26 |
| n | $In_xGa_{1-x}P$:x=0.63 | 25 ⎬ 41 |
| n | $In_xGa_{1-x}P$:x=0.59 | 24 |
| n | $In_xGa_{1-x}P$:x=0.55 | 23 |
| n | $In_xGa_{1-x}P$:x=0.51 | 22 |
| n+ | $In_xGa_{1-x}P$:x=0.48 | 21 ⎭ |
| n+ | AlInP | 110 ⎫ |
| n++ | $In_xGa_{1-x}P$:x=0.48 | 111 |
| p++ | AlGaAs | 112 ⎬ 50a |
| p+ | AlInP | 113 ⎭ |
| p | $In_xGa_{1-x}P$:x=0.48 | 114 |
| p | GaAs | 115 ⎫ 40b |
| n | GaAs | 116 ⎭ |
| n | $In_xGa_{1-x}P$:x=0.48 | 117 |
| n+ | AlInP | 118 ⎫ |
| n++ | $In_xGa_{1-x}P$:x=0.48 | 119 |
| p++ | AlGaAs | 120 ⎬ 50b |
| p+ | AlInP | 121 ⎭ |
| p | AlInP | 122 |
| p | AlInGaP | 323 ⎫ 40c |
| n | AlInGaP | 324 ⎭ |
| n | AlInP | 125 |
| n | GaAs | 126 |
| n | $In_xGa_{1-x}P$:x=0.48 | 131 |
| | GaAs substrate | 130 |

## FIG.8

| | | |
|---|---|---|
| n | GaAs | 126 |
| n | AlInP | 125 |
| n | AlInGaP | 324 } 40c |
| p | AlInGaP | 323 |
| p | AlInP | 122 |
| p+ | AlInP | 121 } 50b |
| p++ | AlGaAs | 120 |
| n++ | $In_xGa_{1-x}P$:x=0.48 | 119 |
| n+ | AlInP | 118 |
| n | $In_xGa_{1-x}P$:x=0.48 | 117 |
| n | GaAs | 116 } 40b |
| p | GaAs | 115 |
| p | $In_xGa_{1-x}P$:x=0.48 | 114 |
| p+ | AlInP | 113 } 50a |
| p++ | AlGaAs | 112 |
| n++ | $In_xGa_{1-x}P$:x=0.48 | 111 |
| n+ | AlInP | 110 |
| n+ | $In_xGa_{1-x}P$:x=0.48 | 21 |
| n | $In_xGa_{1-x}P$:x=0.51 | 22 |
| n | $In_xGa_{1-x}P$:x=0.55 | 23 |
| n | $In_xGa_{1-x}P$:x=0.59 | 24 |
| n | $In_xGa_{1-x}P$:x=0.63 | 25 } 41 |
| n | $In_xGa_{1-x}P$:x=0.67 | 26 |
| n | $In_xGa_{1-x}P$:x=0.71 | 27 |
| n | $In_xGa_{1-x}P$:x=0.75 | 28 |
| n | $In_xGa_{1-x}P$:x=0.79 | 29 |
| n | $In_xGa_{1-x}P$:x=0.82 | 30 |
| n | InGaP | 31 |
| n | InGaAs | 32 } 40a |
| p | InGaAs | 33 |
| p | InGaP | 34 |
| p | InGaAs | 35 |
| | ///////// | 102 |
| | | 101 |

# FIG.9

| | | |
|---|---|---|
| 128 | 226 | |

| n | GaAs | 127 |
| n | AlInP | 125 |
| n | $In_xGa_{1-x}P$:x=0.48 | 224 |
| p | $In_xGa_{1-x}P$:x=0.48 | 223 |
| p | AlInP | 122 |
| p+ | AlInP | 121 |
| p++ | AlGaAs | 120 |
| n++ | $In_xGa_{1-x}P$:x=0.48 | 119 |
| n+ | AlInP | 118 |
| n | $In_xGa_{1-x}P$:x=0.48 | 117 |
| n | InGaAs | 216 |
| p | InGaAs | 215 |
| p | $In_xGa_{1-x}P$:x=0.48 | 114 |
| p+ | AlInP | 113 |
| p++ | AlGaAs | 112 |
| n++ | $In_xGa_{1-x}P$:x=0.48 | 111 |
| n+ | AlInP | 110 |
| n+ | $In_xGa_{1-x}P$:x=0.48 | 21 |
| n | $In_xGa_{1-x}P$:x=0.51 | 22 |
| n | $In_xGa_{1-x}P$:x=0.55 | 23 |
| n | $In_xGa_{1-x}P$:x=0.59 | 24 |
| n | $In_xGa_{1-x}P$:x=0.63 | 25 |
| n | $In_xGa_{1-x}P$:x=0.67 | 26 |
| n | $In_xGa_{1-x}P$:x=0.71 | 27 |
| n | $In_xGa_{1-x}P$:x=0.75 | 28 |
| n | $In_xGa_{1-x}P$:x=0.79 | 29 |
| n | $In_xGa_{1-x}P$:x=0.82 | 30 |
| n | InGaP | 31 |
| n | InGaAs | 32 |
| p | InGaAs | 33 |
| p | InGaP | 34 |
| p | InGaAs | 203 |
| | | 202 |
| | | 201 |

40c: 224, 223
50b: 121, 120, 119, 118
40b: 216, 215
50a: 113, 112, 111, 110
41: 21–30
40a: 32, 33

## FIG.10

| | | |
|---|---|---|
| p | InGaAs | 203 |
| p | InGaP | 34 |
| p | InGaAs | 33 |
| n | InGaAs | 32 |
| n | InGaP | 31 |
| n | $In_xGa_{1-x}P:x=0.82$ | 30 |
| n | $In_xGa_{1-x}P:x=0.79$ | 29 |
| n | $In_xGa_{1-x}P:x=0.75$ | 28 |
| n | $In_xGa_{1-x}P:x=0.71$ | 27 |
| n | $In_xGa_{1-x}P:x=0.67$ | 26 |
| n | $In_xGa_{1-x}P:x=0.63$ | 25 |
| n | $In_xGa_{1-x}P:x=0.59$ | 24 |
| n | $In_xGa_{1-x}P:x=0.55$ | 23 |
| n | $In_xGa_{1-x}P:x=0.51$ | 22 |
| n+ | $In_xGa_{1-x}P:x=0.48$ | 21 |
| n+ | AlInP | 110 |
| n++ | $In_xGa_{1-x}P:x=0.48$ | 111 |
| p++ | AlGaAs | 112 |
| p+ | AlInP | 113 |
| p | $In_xGa_{1-x}P:x=0.48$ | 114 |
| p | InGaAs | 215 |
| n | InGaAs | 216 |
| n | $In_xGa_{1-x}P:x=0.48$ | 117 |
| n+ | AlInP | 118 |
| n++ | $In_xGa_{1-x}P:x=0.48$ | 119 |
| p++ | AlGaAs | 120 |
| p+ | AlInP | 121 |
| p | AlInP | 122 |
| p | $In_xGa_{1-x}P:x=0.48$ | 223 |
| n | $In_xGa_{1-x}P:x=0.48$ | 224 |
| n | AlInP | 125 |
| n | GaAs | 226 |
| | Ge substrate | 230 |

40a (33, 32)
41 (30–21)
50a (110, 111, 112, 113)
40b (215, 216)
50b (118, 119, 120, 121)
40c (223, 224)

## FIG.11

| | | |
|---|---|---|
| | | 201 |
| ///////////////////// | | 202 |
| p | InGaAs | 203 |
| p | InGaP | 34 |
| p | InGaAs | 33 } 40a |
| n | InGaAs | 32 |
| n | InGaP | 31 |
| n | $In_xGa_{1-x}P$:x=0.82 | 30 |
| n | $In_xGa_{1-x}P$:x=0.79 | 29 |
| n | $In_xGa_{1-x}P$:x=0.75 | 28 |
| n | $In_xGa_{1-x}P$:x=0.71 | 27 |
| n | $In_xGa_{1-x}P$:x=0.67 | 26 |
| n | $In_xGa_{1-x}P$:x=0.63 | 25 |
| n | $In_xGa_{1-x}P$:x=0.59 | 24 |
| n | $In_xGa_{1-x}P$:x=0.55 | 23 |
| n | $In_xGa_{1-x}P$:x=0.51 | 22 |
| n+ | $In_xGa_{1-x}P$:x=0.48 | 21 |
| n+ | AlInP | 110 |
| n++ | $In_xGa_{1-x}P$:x=0.48 | 111 } 50a |
| p++ | AlGaAs | 112 |
| p+ | AlInP | 113 |
| p | $In_xGa_{1-x}P$:x=0.48 | 114 |
| p | InGaAs | 215 } 40b |
| n | InGaAs | 216 |
| n | $In_xGa_{1-x}P$:x=0.48 | 117 |
| n+ | AlInP | 118 |
| n++ | $In_xGa_{1-x}P$:x=0.48 | 119 } 50b |
| p++ | AlGaAs | 120 |
| p+ | AlInP | 121 |
| p | AlInP | 122 |
| p | $In_xGa_{1-x}P$:x=0.48 | 223 } 40c |
| n | $In_xGa_{1-x}P$:x=0.48 | 224 |
| n | AlInP | 125 |
| n | GaAs | 226 |
| | Ge substrate | 230 |

41 (brackets layers 30–21)

FIG.12

| n | GaAs | | | 226 | |
|---|------|---|---|-----|---|
| n | AlInP | | | 125 | |
| n | $In_xGa_{1-x}P$:x=0.48 | | | 224 | } 40c |
| p | $In_xGa_{1-x}P$:x=0.48 | | | 223 | |
| p | AlInP | | | 122 | |
| p+ | AlInP | | | 121 | |
| p++ | AlGaAs | | | 120 | } 50b |
| n++ | $In_xGa_{1-x}P$:x=0.48 | | | 119 | |
| n+ | AlInP | | | 118 | |
| n | $In_xGa_{1-x}P$:x=0.48 | | | 117 | |
| n | InGaAs | | | 216 | } 40b |
| p | InGaAs | | | 215 | |
| p | $In_xGa_{1-x}P$:x=0.48 | | | 114 | |
| p+ | AlInP | | | 113 | |
| p++ | AlGaAs | | | 112 | } 50a |
| n++ | $In_xGa_{1-x}P$:x=0.48 | | | 111 | |
| n+ | AlInP | | | 110 | |
| n+ | $In_xGa_{1-x}P$:x=0.48 | | | 21 | |
| n | $In_xGa_{1-x}P$:x=0.51 | | | 22 | |
| n | $In_xGa_{1-x}P$:x=0.55 | | | 23 | |
| n | $In_xGa_{1-x}P$:x=0.59 | | | 24 | |
| n | $In_xGa_{1-x}P$:x=0.63 | | | 25 | |
| n | $In_xGa_{1-x}P$:x=0.67 | | | 26 | } 41 |
| n | $In_xGa_{1-x}P$:x=0.71 | | | 27 | |
| n | $In_xGa_{1-x}P$:x=0.75 | | | 28 | |
| n | $In_xGa_{1-x}P$:x=0.79 | | | 29 | |
| n | $In_xGa_{1-x}P$:x=0.82 | | | 30 | |
| n | InGaP | | | 31 | |
| n | InGaAs | | | 32 | } 40a |
| p | InGaAs | | | 33 | |
| p | InGaP | | | 34 | |
| p | InGaAs | | | 203 | |
| | | | | 202 | |
| | | | | 201 | |

## FIG.13

| | | |
|---|---|---|
| n | GaAs | 127 |
| n | AlInP | 125 |
| n | AlInGaP | 422 |
| p | AlInGaP | 423 |
| p | AlInP | 122 |
| p+ | AlInP | 121 |
| p++ | AlGaAs | 120 |
| n++ | $In_xGa_{1-x}P$:x=0.48 | 119 |
| n+ | AlInP | 118 |
| n | $In_xGa_{1-x}P$:x=0.48 | 117 |
| n | InGaAs | 216 |
| p | InGaAs | 215 |
| p | $In_xGa_{1-x}P$:x=0.48 | 114 |
| p+ | AlInP | 113 |
| p++ | AlGaAs | 112 |
| n++ | $In_xGa_{1-x}P$:x=0.48 | 111 |
| n+ | AlInP | 110 |
| n+ | $In_xGa_{1-x}P$:x=0.48 | 21 |
| n | $In_xGa_{1-x}P$:x=0.51 | 22 |
| n | $In_xGa_{1-x}P$:x=0.55 | 23 |
| n | $In_xGa_{1-x}P$:x=0.59 | 24 |
| n | $In_xGa_{1-x}P$:x=0.63 | 25 |
| n | $In_xGa_{1-x}P$:x=0.67 | 26 |
| n | $In_xGa_{1-x}P$:x=0.71 | 27 |
| n | $In_xGa_{1-x}P$:x=0.75 | 28 |
| n | $In_xGa_{1-x}P$:x=0.79 | 29 |
| n | $In_xGa_{1-x}P$:x=0.82 | 30 |
| n | InGaP | 31 |
| n | InGaAs | 32 |
| p | InGaAs | 33 |
| p | InGaP | 34 |
| p | InGaAs | 203 |
| | | 202 |
| | | 201 |

128  226

40c  50b  40b  50a  41  40a

## FIG.14

| | | |
|---|---|---|
| p | InGaAs | 203 |
| p | InGaP | 34 |
| p | InGaAs | 33 } 40a |
| n | InGaAs | 32 |
| n | InGaP | 31 |
| n | $In_xGa_{1-x}P$:x=0.82 | 30 |
| n | $In_xGa_{1-x}P$:x=0.79 | 29 |
| n | $In_xGa_{1-x}P$:x=0.75 | 28 |
| n | $In_xGa_{1-x}P$:x=0.71 | 27 |
| n | $In_xGa_{1-x}P$:x=0.67 | 26 |
| n | $In_xGa_{1-x}P$:x=0.63 | 25 } 41 |
| n | $In_xGa_{1-x}P$:x=0.59 | 24 |
| n | $In_xGa_{1-x}P$:x=0.55 | 23 |
| n | $In_xGa_{1-x}P$:x=0.51 | 22 |
| n+ | $In_xGa_{1-x}P$:x=0.48 | 21 |
| n+ | AlInP | 110 |
| n++ | $In_xGa_{1-x}P$:x=0.48 | 111 } 50a |
| p++ | AlGaAs | 112 |
| p+ | AlInP | 113 |
| p | $In_xGa_{1-x}P$:x=0.48 | 114 |
| p | InGaAs | 215 } 40b |
| n | InGaAs | 216 |
| n | $In_xGa_{1-x}P$:x=0.48 | 117 |
| n+ | AlInP | 118 |
| n++ | $In_xGa_{1-x}P$:x=0.48 | 119 } 50b |
| p++ | AlGaAs | 120 |
| p+ | AlInP | 121 |
| p | AlInP | 122 |
| p | AlInGaP | 423 } 40c |
| n | AlInGaP | 422 |
| n | AlInP | 125 |
| n | GaAs | 226 |
| | Ge substrate | 230 |

## FIG.15

| | | |
|---|---|---|
| | | ─ 201 |
| ////////// | | ─ 202 |
| p | InGaAs | ─ 203 |
| p | InGaP | ─ 34 |
| p | InGaAs | ─ 33 }40a |
| n | InGaAs | ─ 32 |
| n | InGaP | ─ 31 |
| n | $In_xGa_{1-x}P$:x=0.82 | ─ 30 |
| n | $In_xGa_{1-x}P$:x=0.79 | ─ 29 |
| n | $In_xGa_{1-x}P$:x=0.75 | ─ 28 |
| n | $In_xGa_{1-x}P$:x=0.71 | ─ 27 |
| n | $In_xGa_{1-x}P$:x=0.67 | ─ 26 |
| n | $In_xGa_{1-x}P$:x=0.63 | ─ 25 } 41 |
| n | $In_xGa_{1-x}P$:x=0.59 | ─ 24 |
| n | $In_xGa_{1-x}P$:x=0.55 | ─ 23 |
| n | $In_xGa_{1-x}P$:x=0.51 | ─ 22 |
| n+ | $In_xGa_{1-x}P$:x=0.48 | ─ 21 |
| n+ | AlInP | ─ 110 |
| n++ | $In_xGa_{1-x}P$:x=0.48 | ─ 111 |
| p++ | AlGaAs | ─ 112 } 50a |
| p+ | AlInP | ─ 113 |
| p | $In_xGa_{1-x}P$:x=0.48 | ─ 114 |
| p | InGaAs | ─ 215 } 40b |
| n | InGaAs | ─ 216 |
| n | $In_xGa_{1-x}P$:x=0.48 | ─ 117 |
| n+ | AlInP | ─ 118 |
| n++ | $In_xGa_{1-x}P$:x=0.48 | ─ 119 |
| p++ | AlGaAs | ─ 120 } 50b |
| p+ | AlInP | ─ 121 |
| p | AlInP | ─ 122 |
| p | AlInGaP | ─ 423 } 40c |
| n | AlInGaP | ─ 422 |
| n | AlInP | ─ 125 |
| n | GaAs | ─ 226 |
| | Ge substrate | ─ 230 |

## FIG.16

| | | |
|---|---|---|
| n | GaAs | — 226 |
| n | AlInP | — 125 |
| n | AlInGaP | — 422 |
| p | AlInGaP | — 423 |
| p | AlInP | — 122 |
| p+ | AlInP | — 121 |
| p++ | AlGaAs | — 120 |
| n++ | $In_xGa_{1-x}P$:x=0.48 | — 119 |
| n+ | AlInP | — 118 |
| n | $In_xGa_{1-x}P$:x=0.48 | — 117 |
| n | InGaAs | — 216 |
| p | InGaAs | — 215 |
| p | $In_xGa_{1-x}P$:x=0.48 | — 114 |
| p+ | AlInP | — 113 |
| p++ | AlGaAs | — 112 |
| n++ | $In_xGa_{1-x}P$:x=0.48 | — 111 |
| n+ | AlInP | — 110 |
| n+ | $In_xGa_{1-x}P$:x=0.48 | — 21 |
| n | $In_xGa_{1-x}P$:x=0.51 | — 22 |
| n | $In_xGa_{1-x}P$:x=0.55 | — 23 |
| n | $In_xGa_{1-x}P$:x=0.59 | — 24 |
| n | $In_xGa_{1-x}P$:x=0.63 | — 25 |
| n | $In_xGa_{1-x}P$:x=0.67 | — 26 |
| n | $In_xGa_{1-x}P$:x=0.71 | — 27 |
| n | $In_xGa_{1-x}P$:x=0.75 | — 28 |
| n | $In_xGa_{1-x}P$:x=0.79 | — 29 |
| n | $In_xGa_{1-x}P$:x=0.82 | — 30 |
| n | InGaP | — 31 |
| n | InGaAs | — 32 |
| n | InGaAs | — 33 |
| p | InGaP | — 34 |
| p | InGaAs | — 203 |
| | | — 202 |
| | | — 201 |

40c (422, 423)
50b (121, 120, 119, 118)
40b (216, 215)
50a (113, 112, 111, 110)
41 (21–30)
40a (32, 33, 34)

## FIG.17

| | | |
|---|---|---|
| n++ | $In_xGa_{1-x}P$:x=0.48 | 111 |
| n+ | AlInP | 110 |
| n+ | $In_xGa_{1-x}P$:x=0.48 | 21 |
| n | $In_xGa_{1-x}P$:x=0.51 | 22 |
| n | $In_xGa_{1-x}P$:x=0.55 | 23 |
| n | $In_xGa_{1-x}P$:x=0.59 | 24 |
| n | $In_xGa_{1-x}P$:x=0.63 | 25 |
| n | $In_xGa_{1-x}P$:x=0.67 | 26 |
| n | $In_xGa_{1-x}P$:x=0.71 | 27 |
| n | $In_xGa_{1-x}P$:x=0.75 | 28 |
| n | $In_xGa_{1-x}P$:x=0.79 | 29 |
| n | $In_xGa_{1-x}P$:x=0.82 | 30 |
| n | InGaP | 31 |
| n | InGaAs | 32 |
| p | InGaAs | 33 |
| p | InGaP | 34 |
| p | InGaAs | 35 |
| | | 102 |
| | | 101 |

528

41

40a

FIG.18

FIG.19

## INTERNATIONAL SEARCH REPORT

| | International application No. |
|---|---|
| | PCT/JP2010/051389 |

A. CLASSIFICATION OF SUBJECT MATTER
*H01L31/068*(2006.01)i

According to International Patent Classification (IPC) or to both national classification and IPC

B. FIELDS SEARCHED

Minimum documentation searched (classification system followed by classification symbols)
H01L31/00-31/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | J.F.Geisz et al., "Inverted GaInP/(In)GaAs/ InGaAs triple-junction solar cells with low-stress metamorphic bottom junctions", 33rd IEEE Photovoltaic Specialists Conference, 11-16 May 2008 | 1-15 |
| X | J.F.Geisz et al., "High-efficiency GaInP/GaAs/ InGaAs triple-junction solar cells grown inverted with a metamorphic bottom junction", Applied Physics Letters, Vol.91, No.2 (2007), 023502 | 1-15 |
| P,X | JP 2009-141135 A (Sharp Corp.), 25 June 2009 (25.06.2009), (Family: none) | 1-15 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 March, 2010 (17.03.10) | 30 March, 2010 (30.03.10) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2010/051389

C (Continuation).    DOCUMENTS CONSIDERED TO BE RELEVANT

| Category* | Citation of document, with indication, where appropriate, of the relevant passages | Relevant to claim No. |
|---|---|---|
| A | JP 63-193546 A  (Nippon Telegraph And Telephone Corp.), 10 August 1988 (10.08.1988), (Family: none) | 1-15 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **J. F. Geisz et al.** Inverted GaInP/GaAs/InGaAs triple-junction solar cells with low-stress metamorphic bottom junctions. *33th IEEE Photovoltaic Specialists Conference,* 2008